(19) Europäisches Patentamt
European Patent Office
Office européen des brevets

(11) EP 1 230 708 B1

(12) **EUROPÄISCHE PATENTSCHRIFT**

(45) Veröffentlichungstag und Bekanntmachung des Hinweises auf die Patenterteilung:
**17.10.2007 Patentblatt 2007/42**

(21) Anmeldenummer: **00975881.4**

(22) Anmeldetag: **18.10.2000**

(51) Int Cl.:
***H01M 10/40*** *(2006.01)* ***H01M 4/62*** *(2006.01)*
***H01M 4/02*** *(2006.01)*

(86) Internationale Anmeldenummer:
**PCT/EP2000/010259**

(87) Internationale Veröffentlichungsnummer:
**WO 2001/033656 (10.05.2001 Gazette 2001/19)**

(54) **FOLIEN FÜR ELEKTROCHEMISCHE BAUELEMENTE SOWIE VERFAHREN ZU DEREN HERSTELLUNG**

FILMS FOR ELECTROCHEMICAL COMPONENTS AND METHOD FOR PRODUCING THE SAME

PELLICULES POUR ELEMENTS ELECTROCHIMIQUES ET PROCEDES PERMETTANT DE LES PRODUIRE

(84) Benannte Vertragsstaaten:
**AT BE CH CY DE DK ES FI FR GB GR IE IT LI LU MC NL PT SE**

(30) Priorität: **29.10.1999 DE 19952335**

(43) Veröffentlichungstag der Anmeldung:
**14.08.2002 Patentblatt 2002/33**

(73) Patentinhaber: **Fraunhofer-Gesellschaft zur Förderung der angewandten Forschung e.V.**
**80686 München (DE)**

(72) Erfinder:
- **BIRKE, Peter**
  **73479 Ellwangen (DE)**
- **BIRKE-SALAM, Fatima**
  **73479 Ellwangen (DE)**

(74) Vertreter: **Olgemöller, Luitgard Maria**
**Leonhard - Olgemöller - Fricke,**
**Patentanwälte,**
**Postfach 10 09 62**
**80083 München (DE)**

(56) Entgegenhaltungen:
**WO-A-00/13249** **WO-A-00/24068**
**WO-A-00/63984** **WO-A-95/16285**
**WO-A-97/49106** **US-A- 5 972 055**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 230 708 B1

## Beschreibung

Die vorliegende Erfindung betrifft neuartige Materialien mit elektrochemischen Eigenschaften, und zwar insbesondere Folien und daraus hergestellte Schichtverbünde sowie pastöse Massen, die für die Herstellung dieser Folien geeignet sind. Die Erfindung eignet sich für die Herstellung von Batterien, Akkumulatoren, elektrochromen Elementen oder dergleichen, insbesondere für wiederaufladbare Systeme in Folientechnologie, die nachstehend auch als Zellen oder ganz allgemein als "Systeme" bezeichnet werden. Diese Systeme sollen unter anderem auch solche umfassen, die im angelsächsischen Sprachraum mit *primary* und *secondary batteries, systems* und *cells* bezeichnet werden.

Seit Beginn der siebziger Jahre hat man versucht, elektrochemische Bauelemente wie Akkumulatoren oder dergleichen in Form dünner Schichten zu erzeugen. Ziel ist es, Folienverbünde zu erhalten, die einerseits so flexibel sind, daß man sie beispielsweise aufrollen oder einer anderen gewünschten Form anpassen kann, und die andererseits durch eine extrem hohe Kontaktfläche zwischen den einzelnen elektrochemischen Bestandteilen wie Elektroden und Elektrolyten, bezogen auf das eingesetzte Volumen an elektrochemisch aktivem Material, besonders günstige Lade- und Entladeeigenschaften aufweisen. Diese Bauweise (Folientechnologie) sollte mit wenigen Ausnahmen wesentliche Vorteile bieten. Nicht anwenden wird man sie meist nur dann nicht, wenn (a) extreme Anforderungen an das System zu stellen sind oder (b) besondere elektrochemische Vorteile vorliegen.

In der Patentliteratur ist eine Reihe von Verfahren zum Herstellen solcher Folien beschrieben. Das US-Patent 5,009,970 beschreibt die Herstellung eines festen Polymerelektrolyten für die Verwendung in einer elektrochemischen Zelle (beispielsweise einer wiederaufladbaren Lithiumzelle). Als Polymer wird Polyethylenoxid (PEO) eingesetzt, das mit einem geeigneten Lithiumsalz in Wasser versetzt wird, wodurch ein Komplex aus den beiden Bestandteilen gebildet wird. Durch Bestrahlen wird das PEO vernetzt. Man erhält ein Hydrogel, das anschließend im Vakuum getrocknet werden soll. Das US Patent 5,041,346 beschreibt ebenfalls eine oxymethylenvernetzte Variante eines Ethylenoxid-Polymerelektrolyten, in der zusätzlich ein Weichmacher enthalten ist, der vorzugsweise ionensolvatisierende Eigenschaften aufweist, z.B. ein dipolares aprotisches Solvens wie $\gamma$-Butyrolacton sein kann. Allerdings ist berichtet worden, daß die lonenleitfähigkeit solcher Komplexe im Vergleich zu reinem festem Lithiumsalz zwar drastisch erhöht ist, für den Einsatz als Elektrolytschicht in elektrochemischen Bauelementen jedoch nicht ausreicht.

Die US 5,707,759 beschreibt ein Anodenmaterial, ebenfalls für eine wiederaufladbare Lithiumzelle, wobei das polymere Material in diesem Falle aus Polyvinylalkohol und Polyvinylbutyral erzeugt wird. Diese Materialien werden in einem Lösungsmittel (Wasser, Alkohol, N-Methylpyrrolidon) gelöst und mit dem elektrochemisch aktivierbaren Material (Graphit) versetzt. Die entstandene Paste wird auf einem Träger ausgestrichen und getrocknet.

Die US 5.456.000 beschreibt wiederaufladbare Batteriezellen, die durch Laminierung von Elektroden- und Elektrolytzellen aus selbsttragenden Folien erzeugt werden. Als positive Elektrode wird ein Film oder eine Membran eingesetzt, die getrennt aus $LiMn_2O_4$-Pulver in einer Matrix-Lösung aus einem Copolymeren hergestellt und anschließend getrocknet wurde. Die negative Elektrode besteht aus einer getrockneten Beschichtung einer pulverisierten Kohlenstoff-Dispersion in einer Matrix-Lösung eines Copolymeren. Zwischen den Elektrodenschichten wird eine Elektrolyt/Separatormembran angeordnet. Hierfür wird ein Poly(vinylidenfluorid)-Hexafluorpropylen-Copolymeres in Aceton oder THF oder dgl. mit einer großen Menge einer Substanz wie Propylencarbonat oder Dimethylphthalat oder einem anderen höhersiedenden Plastifizierer umgesetzt, die sich als Lösungsmittel für Elektrolytsalze eignet. Aus diesen Bestandteilen wird ein Film erzeugt. Um die Batterie zu aktivieren, wird sie in die entsprechende Elektrolytlösung eingetaucht, wobei sich die Separatormembran mit der Elektrolytlösung vollsaugt. Der hohe Anteil an Plastifizierer bewirkt, daß die Folien eine sehr schlechte Alterungsbeständigkeit aufweisen; nach Lagerzeiten von mehreren Wochen werden Konsistenzänderungen und Brüchigkeit bis zum Zerfall zu Pulver beobachtet, was möglicherweise aufgrund einer Interaktion mit der Umgebungsfeuchte beruht. In der als bevorzugt beschriebenen Variante wird daher das Plastifiziermittel zuvor ausgetrieben, was durch aufwendige Waschschritte erfolgen muß. Außerdem wird die Aufnahmefähigkeit für den Elektrolyten verringert. Durch den Waschschritt entstehen außerdem Spannungen und Dekontaktierungen in einer mit dieser Folie hergestellten Zelle; die mechanische Stabilität ist stark beeinträchtigt. Auch beobachtet man elektrochemische Zersetzungen, wenn die Zelle später aktiviert wird. Da die Folien vor dem Entfernen des Plastifizierers laminiert werden, kann die Lamination nur bei einer gegenüber dem Schmelzpunkt des Polymers (ca. 145-150°C) reduzierten Temperatur erfolgen, die je nach Anteil an Plastifizierer 80-130 °C nicht überschreiten darf. Ein weiterer Nachteil ist der durch die Porenstruktur entstandene direkte Kontakt des sodann eingefüllten Flüssigelektrolyten mit den Kontaktnetzen, bei denen es sich in der Regel um Aluminium auf der positiven Seite und Kupfer auf der negativen Seite handelt. Es kann hierdurch in der Folge zu Zersetzungen des Elektrolyten zwischen zwei Metallen ohne Referenz kommen.

Alle Folien des voranstehend diskutierten Standes der Technik weisen einen oder mehrere der folgenden Nachteile auf:

(I) Die Druck- bzw. Hitze-Laminierung der einzelnen Folien zu einem elektrochemischen Schichtverbund ist unzureichend.

(II) Die elektrochemische Stabilität der aus dem Folienlaminat erzeugten Elemente ist ungenügend.

(III) Die Folien schrumpfen, reißen oder verkleben nach Extraktion des Lösungsmittels.

(IV) Die Alterungsstabilität der anwendungsbereiten Folien ist unzureichend, insbesondere bei chemischen oder mechanischen Belastungen, selbst wenn diese nur sehr gering sind.

(V) Eine Reihe der vorgeschlagenen Plastifizierer wie Dialkylphthalate sind giftig bzw. gewässertoxisch. Andere sind nicht oder nur schwer recyclierbar.

(VI) Manche der Folien sind hygroskopisch. In einem solchen Falle wird das Laminat bei der Lamination aufgrund von Wärme- und Druckeinwirkung durch Wasserdampfblasen dekontaktiert und teilweise zerstört. Insbesondere Folien für Lithiumzellen und für alle Systeme, bei denen selbst unter Ausnutzung eines möglichen Übespannungspotentials Wasser zersetzt werden kann, dürfen nicht hygroskopisch sein.

(VII) Die Flexibilität und Stabilität der erhaltenen Folie ist nicht ausreichend, um aufgerollte elektrochemisch aktive Systeme daraus herzustellen.

In der WO 95/16285 A1 werden Kathoden-, Anoden- und Polymerelektrolyt-Pasten beschrieben, die wiederum unter Einsatz von Ethylenoxid hergestellt werden. Die Mischungen enthalten Propylencarbonat und Triglyme als Lösungsmittel in einem Anteil von 10-50 Gew.-%, bezogen auf die Gesamtmischung der Pasten, die im Falle der Elektrodenpasten jeweils maximal ca. 65 Gew.-% Elektrodenmaterial enthalten können. Die Polymerelektrolyt-Paste ist frei von unlöslichem Festkörperelektrolyt.

Die WO 97/49106 A beschreibt feste oder teilweise feste Verbundmaterialien für Elektrolyte in elektrochemischen Anordnungen, die durch Vermischen eines Alkali-Triflatsalzes mit Polyethylenoxid, einer Mischung aus anorganischen Füllmitteln mit leichtem Molekulargewicht wie $LI_2O$ oder MgO sowie einer Solvens-Mischung von Estern (insbesondere Ethylencarbonat, Propylencarbonat und Dimethylcarbonat) und Ethern (insbesondere 1,2-Dimethoxyethern) erhältlich sind.

Nach der Lehre der US 5,972,055 A soll Plastifizierer sowohl in die Elektrodenfolie als auch in die Separatorfolie eingearbeitet werden, ohne ihn später wieder herauszulösen, da der Plastifizierer gleichzeitig die Funktion des Lösungsmittels für den Flüssigelektrolyten haben soll. Die eingesetzten Plastifizierermengen sind sehr hoch; in der Regel zwischen etwa 20 und über 30 Gew.-% der für die Folien eingesetzten Pasten.

**Aufgabe** der vorliegenden Erfindung ist die Bereitstellung von Folien mit verbesserten Eigenschaften, aus denen sich elektrochemische Bauelemente in Form dünner Schichtverbünde herstellen lassen. Die so hergestellten Folien sollen die genannten Nachteile des Standes der Technik nicht aufweisen und sich insbesondere bei Temperaturen im Bereich des Polymerenschmelzpunkts laminieren lassen. Außerdem sollen pastöse Massen bereitgestellt werden, aus denen sich derartige Folien herstellen lassen.

Insbesondere soll die Erfindung Folien mit sehr hoher Flexibilität und Reißfestigkeit bereitstellen, wobei die daraus laminierten Schichtverbünde mit elektrochemischen Eigenschaften Produkte wie wiederaufladbare Batterien (Akkumulatoren), elektrochrome Bauelemente oder dergleichen liefern, die ebenfalls eine hohe Flexibilität und sehr gute Elektronen- und Ionenleitungseigenschaften aufweisen.

Diese Aufgabe wird dadurch gelöst, daß erfindungsgemäß in elektrochemischen Bauelementen verwendbare, pastöse Massen gemäß Anspruch 1 bereitgestellt werden.

Aus diesen Massen lassen sich Folien mit den gewünschten Eigenschaften fertigen, die dann ihrerseits zu entsprechenden elektrochemischen Bauelementen verbunden werden können.

Der Ausdruck "in elektrochemischen Bauelementen verwendbar" impliziert dabei, daß das elektrochemisch aktivierbare anorganische Material in Form einer Festsubstanz ein ionenleitendes oder elektronenleitendes Material sein muß, das sich als Elektrodenmaterial oder Festelektrolyt eignet.

Einen im Plastifizierer löslichen, von (B) verschiedenen Leiter (unabhängig davon, ob Ionen-, Elektronen- oder gemischter Leiter) soll diese Mischung nicht aufweisen.

Die Erfindung wird auch durch Figuren näher erläutert, wobei **die Figuren 1-3** die Zykeldaten dreier Zellen zeigen, die gemäß Beispiel 1 herstellt wurden.

Die Masse erhält ihre pastöse Konsistenz durch die Verwendung einer geeigneten Matrix (A). Der Ausdruck "pastös" soll dabei bedeuten, daß die Masse nach ihrer Herstellung mit Hilfe von gängigen Pastenauftragsverfahren verarbeitbar ist, beispielsweise kalandriert, extrudiert, gegossen, aufgestrichen, aufgespachtelt, aufgerakelt oder mit diversen Druckverfahren auf einem Untergrund aufgebracht werden kann, wobei vor allem, aber nicht ausschließlich selbsttragende Schichten erzeugt werden sollen. Je nach Bedarf kann die Masse dabei relativ dünnflüssig bis sehr zäh gehalten werden.

Für die Matrix (A) kann eine Vielzahl von Materialien verwendet werden. Dabei kann man mit lösungsmittelfreien oder lösungsmittelhaltigen Systemen arbeiten. Als lösungsmittelfreie Systeme eignen sich beispielsweise vernetzbare, flüssige oder pastöse Harzsysteme. Beispiele hierfür sind Harze aus vernetzbaren Additionspolymeren oder Kondensationsharzen. So können beispielsweise Vorkondensate von Phenoplasten (Novolake) oder Aminoplasten eingesetzt werden, die nach Ausformen der pastösen Masse zur Schicht eines elektrochemischen Schichtverbundes endvernetzt werden. Weitere Beispiele sind ungesättigte, beispielsweise durch Pfropf-Copolymerisation mit Styrol vernetzbare Polyester, durch bifunktionelle Reaktionspartner härtbare Epoxiharze (Beispiel: Bisphenol-A-Epoxiharz, kalt gehärtet mit Polyamid), vernetzbare Polycarbonate wie durch ein Polyol vernetzbares Polyisocyanurat, oder binäres Polymethylmethacrylat, das ebenfalls mit Styrol polymerisiert werden kann. Die pastöse Masse wird dabei jeweils aus dem mehr oder weniger zähflüssigen Vorkondensat bzw. unvernetzten Polymer und dem Plastifizierer als Matrix (A) oder unter Verwendung wesentlicher Bestandteile davon, zusammen mit der Komponente (B), gebildet.

Eine andere Möglichkeit ist die Verwendung von Polymeren oder Polymer-Vorstufen zusammen mit einem Lösungs- oder Quellmittel für das organische Polymer. Im Prinzip besteht hier keine Beschränkung bezüglich der einsetzbaren synthetischen oder natürlichen Polymere. Nicht nur Polymere mit Kohlenstoff-Hauptkette sind möglich, sondern auch Polymere mit Heteroionen in der Hauptkette wie Polyamide, Polyester, Proteine oder Polysaccharide. Die Polymere können Homo- oder Copolymere sein; die Copolymere können statistische Copolymere, Pfropfcopolymere, Blockcopolymere oder Polyblends sein; eine Beschränkung ist hier nicht gegeben. Als Polymere mit reiner Kohlenstoff-Hauptkette sind beispielsweise natürliche oder synthetische Kautschuke verwendbar. Besonders bevorzugt sind fluorierte Kohlenwasserstoff-Polymere wie Teflon, Polyvinylidenfluorid (PVDF) oder Polyvinylchlorid, da hiermit bei den aus der pastösen Masse gebildeten Folien oder Schichten besonders gute wasserabweisende Eigenschaften erzielt werde können. Dies verleiht den damit erzeugten elektochemischen Bauelementen eine besonders gute Langzeitstabilität. Weitere Beispiele sind Polystyrol oder Polyurethan. Als besonders bevorzugte Beispiele für Copolymere seien Copolymere von Teflon und amorphem Fluorpolymer sowie Polyvinylidenfluorid/Hexafluorpropylen (im Handel als Kynarflex erhältlich) genannt. Als Beispiele für Polymere mit Heteroatomen in der Hauptkette seien Polyamide vom Diamin-Dicarbonsäure-Typ oder vom Aminosäure-Typ, Polycarbonate, Polyacetale, Polyether und Acrylharze genannt. Weitere Materialien umfassen natürliche und synthetische Polysacharide (Homo- und Heteroglykane), Proteoglykane, beispielsweise Stärke, Cellulose, Methylcellulose. Auch Substanzen wie Chondroitinsulfat, Hyaluronsäure, Chitin, natürliche oder synthetische Wachse und viele andere Substanzen können eingesetzt werden. Zusätzlich können auch die vorgenannten Harze (Präkondensate) in Lösungs- bzw. Verdünnungsmitteln verwendet werden.

Lösungs- bzw. Quellmittel für die vorgenannten Polymere sind dem Fachmann bekannt.

Ein wesentlicher Bestandteil der Matrix (A) ist ein Plastifiziermittel (auch als Weichmacher bezeichnet) für das bzw. die eingesetzten Polymere. Unter "Plastifizierer" oder "Weichmacher" sollen hier Substanzen verstanden werden, deren Moleküle durch Nebenvalenzen (Van-der-Waals-Kräfte) an die Kunststoffmoleküle gebunden werden und die dadurch die Wechselwirkungskräfte zwischen den Makromolekülen verringern und damit die Erweichungstemperatur und die Sprödigkeit und Härte der Kunststoffe herabsetzen. Damit soll hier auch eine Reihe von Substanzen mit umfaßt sein, die üblicherweise als Quellmittel bezeichnet werden. Das Einarbeiten eines Plastifizierers im erfindungsgemäßen Sinn bewirkt eine hohe mechanische Flexibilität der aus der pastösen Masse erzeugbaren Schicht.

Erfindungsgemäß ist das elektrochemisch aktivierbare Material der pastösen Masse (B) nicht im Plastifizierer (und selbstverständlich auch nicht im gegebenenfalls eingesetzten Lösungs- oder Quellmittel für das Polymere) löslich.

Überraschenderweise wurde festgestellt, daß sich alle oben aufgelisteten Nachteile gleichzeitig vermeiden und weitere, weiter unten aufgelistete besondere Vorteile erzielen lassen, wenn der Plastifizierer unter Substanzen und Mischungen von Substanzen ausgewählt ist, die die Gruppierung

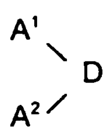

tragen, wobei $A^1$ und $A^2$ unabhängig voneinander $R^1$, $OR^1$, $SR^1$ oder $NHR^1$ bedeuten oder $A^1$ und $A^2$ mit D zusammen einen Hetero-5-Ring ausbilden und D C=O, S=O, C=NH oder $C=CH_2$ bedeuten kann und außerdem dann, wenn D mit $A^1$ und $A^2$ den genannten Hetero-5-Ring bildet, auch O, S, NH oder $CH_2$ bedeuten kann. $R^1$ stellt einen $C_1$-$C_6$-Alkylrest (gerad- oder verzweigtkettig, ggf. auch cyclisch) dar. Bevorzugt ist $R^1$ gleich Methyl, Ethyl, n- oder iso-Propyl, n- oder iso-Butyl.

Unter die vorstehend genannten Kriterien fallen vor allem Carbonate bzw. Ester und deren Schwefel- und Amino-Analoga.

Die räumliche Struktur der erfindungsgemäß als besonders vorteilhaft aufgefundenen Plastifizierer umfaßt, wie aus der obigen Formel leicht erkennbar, die Gruppe $A^1$-D-$A^2$, in der die Bindungen von D entweder durch einen Ringschluß zwischen $A^1$ und $A^2$ unter Ringspannung stehen oder worin D ein vierbindiges Atom enthält, das eine Doppelbindung und zwei Einfachbindungen ausbildet. Daraus resultiert, daß die Gruppe $A^1$-D-$A^2$ eine tetraedrische, planartetraedrische oder planare Grundstruktur aufweist.

In einer bevorzugten Ausgestaltung sind $A^1$ und $A^2$ aus den Gruppen O, $CHR^2$, NH oder S gebildet, wobei $R^2$ Wasserstoff, Methyl oder Ethyl ist, und bilden mit D zusammen einen Hetero-5-Ring. Stärker bevorzugt sind $A^1$ plus $A^2$

in diesem Ring $-E^1-CHR^2-CHR^2-E^2-$, worin $E^1$ und $E^2$ gleich oder verschieden sein können und S, O, $CHR^2$ oder NH bedeuten. Ganz besonders bevorzugte Plastifizierer sind in der nachstehenden Tabelle aufgeführt, die gleichzeitig die Einstufung der Substanz(en) in die jeweilige chemische Gefahrenklasse auflistet.

Tabelle 1

| Name | Aussehen | Summenformel | Einstufung |
|---|---|---|---|
| Dimethylsulfoxid* | **tetraedrisch** | $C_2H_6OS$ | ***$X_i$*** |
| Dimethylcarbonat<br>Ethylmethylcarbonat<br>Diethylcarbonat<br>Methylpropylcarbonat | **tetraedrisch, lineare Anteile** | $C_3H_6O_3$<br>$C_4H_8O_3$<br>$C_5H_{10}O_3$<br>$C_5H_{10}O_3$ | ***unbedenklich*** |
| Ethylencarbonat | **tetraedrisch, Fünfeckring** | $C_3H_4O_3$ | ***$X_i$*** |
| ***1**** Ethylensulfit | | $C_2H_4O_3S$ | ***unbedenklich*** |
| ***2**** N-N'-Ethylenharnstoff | | $C_3H_6N_2O$ | ***$X_n$*** |
| ***3**** Propylencarbonat<br>***$CH_3$-Gruppe*** | etherartig | $C_4H_6O_3$ | ***$X_i$*** |
| ***4**** Dioxolan | | $C_3H_6O_2$ | ***unbedenklich*** |
| ***5**** Tetrahydrofuran | **Fünfeckring, etherartig** | $C_4H_8O$ | ***$X_i$*** |
| ***6**** g-Butyrolacton<br>***O-Gruppe*** | | $C_4H_6O_2$ | ***$X_n$*** |

* Das Dimethylsulfoxid ist aus dem Dimethylcarbonat strukturell ableitbar, indem man die zwei Sauerstoffatome, die mit Einfachbindungen an das zentrale C-Atom des Tetraeders geknüpft sind, wegläßt, und das zentrale C-Atom gegen Schwefel substituiert, *1** Beim Ethylensulfit ist gegenüber dem Ethylencarbonat das zentrale C-Atom im Tetraeder gegen Schwefel substituiert, *2** Beim N-N'-Ethylenharnstoff sind gegenüber dem Ethlyencarbonat die zwei Sauerstoffatome, die mit Einfachbindungen an den Tetraeder geknüpft sind, durch NH-Gruppen ersetzt, *3** Das Propylencarbonat verfügt gegenüber dem Ethylencarbonat über eine zusätzliche $CH_3$-Methylgruppe, die gegen ein Wasserstoff der $CH_2$-Gruppe substituiert ist, *4** Beim Dioxolan ist gegenüber dem Ethylencarbonat das Sauerstoffatom, das mit einer Doppelbindung an das C-Atom des Tetraeders geknüpft ist, durch eine $H_2$-Gruppe ersetzt der Charakter wird dadurch in Richtung eines Ethers verschoben, *5** Das Tetrahydrofuran leitet sich vom Ethylencarbonat ab, indem man das zentrale C-Atom des Tetraeders durch ein Sauerstoffatom sowie die Sauerstoffatome, die durch Einfachbindungen mit dem Tetraeder verknüpft waren durch $CH_2$-Gruppen substituiert, der Tetraeder verschwindet dadurch und es bleibt die Fünfeckringstruktur, der chemische Charakter verschiebt sich in Richtung eines zyklischen Ethers, *6** Das $\gamma$-Butyrolacton wiederum leitet sich vom Tetrahydrofuran durch den Ersatz zweier Wasserstoffe einer $CH_2$-Gruppe, die mit dem Sauerstoffatom des Rings direkt verbunden ist, durch ein Sauerstoffatom ab.

Der Plastifizierer in der erfindungsgemäßen Zusammensetzung besitzt einen direkten Einfluß auf Konsistenz, Homogenität und Flexibilität der Folie. Besonders bevorzugt sind dabei Substanzen mit einer asymmetrischen Ringstruktur; bei einer symmetrischen Ringstruktur werden ebenfalls sehr gut Ergebnisse erzielt, die nur äußerst geringfügig ersterer Gruppe nachstehen. Ohne geschlossenen Ring fällt das Ergebnis etwas zurück, möglicherweise wegen einer höheren Flüchtigkeit. Besonders überraschend sind die Lagerfähigkeit und die Flexibilität des Materials auch bei sehr geringem Plastifiziereranteil deutlich verbessert. Diese Eigenschaften sind umso verblüffender, als viele Substanzen, die unter die Definition des erfindungsgemäß einzusetzenden Plastifizierers fallen, bisher eher als Quellmittel bekannt waren.

Die erfindungsgemäß verbesserte elektrochemische Stabilität der aus den voranstehend beschriebenen Pasten

und Schichten bzw. Folien hergestellten elektrochemischen Bauelemente kann möglicherweise dadurch zustandekommen, daß durch eine elektrochemische Seitenreaktion beim Formieren (erstmaligem Laden und Cyceln) der Zelle auf beiden oder lediglich nur einer der beiden Seiten (i.e. der positive/negative Elektrode) eine dünne, ionen- oder gemischtleitende feste Schicht als Reaktionsprodukt des Plastifizierers mit Lithium und/oder anderen Elektrodenbestandteilen gebildet wird. Insbesondere Schwefel und Stickstoff im Plastifizierer scheinen die Bildung einer solchen Schicht verknüpft mit guter ionischer Leitfähigkeit auf der negativen Seite zu fördern. Die elektrochemische Stabilität gegen Oxidation (positive Seite) wird durch einen Tetraeder und/oder durch einen Ring in der Molekülstruktur des Plastifizierers extrem begünstigt. Substitutionen mit Schwefel, Stickstoff, Wasserstoff oder hieraus gebildeten Gruppen im Molekül scheinen gegenläufig zu sehr hohen Oxidationsstabilitäten zu sein.

Es ist wesentlich, daß der Plastifizierer in einer nicht zu großen Menge eingesetzt wird, und zwar sollen nicht mehr als etwa 5 Gew.-% in der Matrix vorhanden sein, wobei die Menge auf die Menge des elektrochemisch aktivierbaren Materials bezogen ist. Empfehlenswert ist es dabei, die Menge an Plastifizierer immer so gering wie für das jeweilige System möglich zu halten. Wenn es wünschenswert ist, aus verarbeitungstechnischen Überlegungen heraus eine relativ große Menge in die pastöse Masse einzuarbeiten, kann ein Teil des Plastifizierers anschließend (z.B. nach Ausformen der Folie) wieder entfernt werden, beispielsweise durch Vakuumextraktion bei z.B. bis zu $10^{-2}$ mbar, ggf. bei erhöhter Temperatur (bis etwa 150°C, vorzugsweise bei 65-80°C). Alternativ kann die Extraktion bei Umgebungsdruck durch Trocknen und Erwärmen bei vorzugsweise 120°C, ggf. auch bis zu 200°C, erfolgen.

Die erfindungsgemäßen pastösen Massen werden üblicherweise durch Vermischen der erforderlichen Bestandteile, vorzugsweise in Gegenwart eines Lösungsmittels für das organische Polymer oder dessen Vorstufe oder dessen Präpolymere der Matrix (A), hergestellt. Die Anwendung von Druck, z.B. durch Einsatz eines Extruders, ist dabei in der Regel nicht erforderlich, kann aber gegebenenfalls ins Auge gefaßt werden.

Die erfindungsgemäße Feststellung, daß die Anwesenheit von Plastifizierer, besonders der bevorzugten Strukturen, die Eigenschaften der erzeugten Folie deutlich verbessert, wobei aber die Menge dieses Plastifizierers in vorteilhafter Weise möglichst gering gehalten werden sollte, war überraschend. Möglich ist, daß eine unerwartete Eigenschaft der Polymer-Weichmacher-Gemische hierfür mitverantwortlich ist: Wird eine für die Konsistenz der Folie gerade noch tolerierbare Minimalmenge verwendet, so kann die Lamination der Folien erstaunlicherweise bei Temperaturen im Bereich des Schmelzpunkts des Polymeren oder etwas darüber erfolgen, obwohl Polymer-Weichmacher-Gemische in der Regel eine Schmelzpunktdepression zeigen sollten. Hierdurch resultieren Laminate, die über das Polymer laminiert sind und die daher besonders dauerhaft sind und besonders gute Kontakteigenschaften aufweisen. Erfolgt dagegen die Laminierung teilweise über den Plastifizierer, was bei hohen Plastifizierer-Anteilen in der Matrix zwangsläufig der Fall ist, so hat dies nachteilige Folgen u.a. deshalb, weil der Plastifizierer mit der Zeit im Laminat diffundieren kann.

Ein weiterer Vorteil geringer Plastifizierermengen ist die Verminderung des Wassereintransportes in die Folien (Plastifizierer sind meist hygroskopisch), das ggf. dort verbleiben und eingeschlossen werden kann. Es resultiert erfindungsgemäß ein extrem geringer Wassereinschluß bei der Fertigung, und die so hergestellten Folien lassen sich leicht und elegant nach Standardmethoden trocknen.

Die erfindungsgemäßen pastösen Massen eignen sich wie erwähnt für das Erzeugen von dünnen Schichten, z.B. Folien, aus denen Dünnfilm-Batterien und andere entsprechende elektrochemische Bauelemente wie z.B. elektrochrome Bauelemente hergestellt werden können. Die einzelnen Schichten oder Folien dieser Elemente werden auch "Tapes" genannt. Hierfür werden einzelne elektrochemisch aktive bzw. aktivierbare Schichten aufeinander aufgebracht und in innigen Kontakt gebracht.

Die vorliegende Erfindung umfaßt daher weiterhin selbsttragende oder auf einem Substrat aufliegende, elektrochemisch aktive bzw. aktivierbare Schichten oder Folien, bevorzugt in den angegebenen Dicken, die aus den voranstehend beschriebenen pastösen Massen erzeugt werden können. Die Schichten sind vorzugsweise flexibel.

Die Folien erhalten ihre Konsistenz über die oben näher beschriebene Matrix, die aus stützenden Polymeren wie voranstehend beschrieben, die gegebenenfalls (und vorzugsweise) in einem Lösungsmittel wie Aceton löslich sind, sowie einem oder mehreren Plastifizierer(n) (Weichmacher(n)) wie oben beschrieben besteht. Während das gegebenenfalls für die Herstellung der Paste eingesetzte Lösungsmittel während oder nach der Verfestigung der Paste in Folienform vorzugsweise wieder entfernt wird (z.B. durch Ausgasen im Vakuum und/oder durch Wärme), verbleibt der Plastifizierer zumindest anteilig in der entstandenen Folie. Der Verbleib des Plastifizierers trägt dazu bei, daß eine Sedimentation pulverförmiger Bestandteile während der Folienherstellung vermieden wird. Zwar besitzen viele der oben beschriebenen polymeren Zusammensetzungen (z.B. eine bevorzugte Zusammensetzung aus oder unter Verwendung wesentlicher Anteile eines Copolymeren aus Polyvinylidenfluorid/Hexafluorpropylen, (PVDF/HFP, Kynarflex)) einen nur geringen Kristallinitätsgrad, hohe Flexibilität und neigen nur wenig zum Verspröden. Eine mögliche Entmischung und Sedimentation bei der Folienherstellung läßt sich damit jedoch nicht sicher verhindern.

Zur Erzeugung sowohl der selbsttragenden Schichten (Folien, Tapes) als auch der auf einem Substrat aufliegenden Schichten kann auf die üblichen, im Stand der Technik bekannten Verfahren zurückgegriffen werden, die für die entsprechenden Polymermaterialien der Matrix anwendbar sind. Wichtige Techniken sind das sog. Tape-Casting , das sog. "reverse-roll-on-coating", Gießen, Sprayen, Pinseln oder Rollern. Die Verfestigung der pastösen Massen erfolgt

dabei je nach Material beispielsweise durch Härten (von Harzen oder anderen Präkondensaten), durch Vernetzen von Präpolymerisaten oder linearen Polymerisaten, durch Abdampfen von Lösungsmittel oder auf ähnliche Art und Weise. Um selbsttragende Folien zu erhalten, kann beispielsweise eine geeignete pastöse Masse auf Kalandern in der geeigneten Dicke ausgeformt werden. Hier kann auf Standardtechnologie verwiesen werden. Selbsttragende Schichten können auch durch Auftragen der pastösen Masse auf ein Substrat und Abziehen der erzeugten Schicht nach ihrer Verfestigung gebildet werden. Die Beschichtung kann mit üblichen Pastenauftragsverfahren durchgeführt werden. Beispielhaft sei hier das Aufstreichen, Aufrakeln, Aufspritzen, Spincoating und dergleichen genannt. Auch Drucktechniken sind möglich. Die Laminierung von Folien zum Verbund erfolgt bei einer geeigneten Temperatur, für das vorerwähnte System PVDF/HFP z.B. in geeigneter Weise bei 100-250°C, bevorzugt im Bereich von 135-150°C. Gegebenenfalls können Temperaturgradienten gefahren werden. Endlosfolien können dynamisch-kontinuierlich laminiert werden. Der Druck dabei beträgt bevorzugt etwa 0,5 kg/20 $cm^2$.

In einer Ausgestaltung der Erfindung werden vernetzbare Harzmassen (Präkondensate), wie weiter oben für die pastösen Massen beschrieben, eingesetzt und nach Ausformen der Schicht durch UV- oder Elektronenbestrahlung ausgehärtet. Eine Härtung kann natürlich auch thermisch oder chemisch (beispielsweise durch Eintauchen der erzeugten Schicht in ein entsprechendes Bad) bewirkt werden. Gegebenenfalls werden den Massen geeignete Initiatoren oder Beschleuniger oder dgl. für die jeweilige Vernetzung zugesetzt.

Die Herstellung von für elektrochemische Bauelemente vorgesehene Folien gemäß der vorliegenden Erfindung bietet eine Reihe von Vorteilen: (a) Die Fertigung hoher Stückzahlen mit Lagerfähigkeit der Ausgangsmaterialien ist günstig (die noch nicht zum elektrochemischen Schichtverbund verbundenen Schichten lassen sich sehr sicher lagern). (b) Eine flexible und variationsreiche Formgebung ist möglich. (c) Die Folien lassen sich raumsparend lagern (z.B. durch gestapelte und/oder aufgerollte Folienbahnen). (d) Durch die Abwesenheit niedrig siedender Materialien und Einsatz fester Ionenleiter ist eine höhere Temperaturbeständigkeit gegeben. (e) Die Folien sind aufgrund des festen Aggregatzustands der elektrochemisch aktivierbaren Bestandteile auslaufsicher und korrosionsbeständig. (f) Da in bevorzugter Weise im wesentlichen gesundheitlich unbedenkliche Matrices und Plastifizierer eingesetzt werden, können nach dem Gebrauch der Binder wieder extrahiert und die Ausgangsmaterialien durch Filtrieren rückgewonnen und wiederverwertet werden. (g) Es lassen sich verschiedene Elektroden- und Elektrolytmaterialien unabhängig von ihrer Korngröße und -geometrie, ihrer Dichte und ihren funktionalen Gruppen an der Oberfläche in die Folien einarbeiten. Dies gilt auch für Metallpulver, das als elektronischer Leitfähigkeitsverbesserer, auch mit speziellen Oberflächen (z.B. in Form von Flakes wie Nickelflakes) eingesetzt werden kann.

In einer speziellen Ausgestaltung der Erfindung werden die erfindungsgemäß aus den pastösen Massen hergestellten Folien anschließend mit einem zweiten, gelösten Elektrolyten imprägniert. Das kann beispielsweise dadurch geschehen, daß Elektrolytlösung auf die Folie oder den laminierten Folienverbund aufgesprüht oder die Folie bzw. der Folienverbund in die entsprechende Lösung eingetaucht wird. Dies kann in besonders bevorzugter Weise bei solchen Folien/Folienverbünden erfolgen, aus denen ein Überschuß an Plastifizierer zuvor wie voranstehend beschrieben entfernt wurde oder bei denen bereits ursprünglich nur sehr wenig Plastifizierer eingesetzt wurde. Nach dem Befüllen der Folie oder des Folienverbundes wird dieser in vorteilhafter Weise getrocknet, z.B. einige Stunden lang auf 70-90°C gehalten. Bei dieser "Konvertierung" bildet sich eine sehr dünne, flexible, ionenleitende Schicht aus Umsetzungsprodukten von Polymer, Weichmacher und Elektrolyt. Der Elektrolyt wird dabei infolge des beschriebenen Aufnahmeprozesses gelifiziert oder solidifiziert; das so hergestellte Tape oder die Zelle (also die Folie bzw. der Folienverbund) besitzen trotz Verwendung eines gelösten Elektrolyten eine besonders hohe Auslaufsicherheit. Als Elektrolyte eignen sich beispielsweise Salze des Lithiums gut. Besonders vorteilhaft werden $LiClO_4$, $LiNO_3$, $LiBF_4$, $LiPF_6$, $LiSO_3CF_3$ oder $LiC(SO_2CF_3)_3$ oder Mischungen hiervon eingesetzt. Als Lösungsmittel werden bevorzugt Plastifizierer, wie voranstehend als erfindungsgemäßer Bestandteil der Matrix (A) definiert, eingesetzt, darunter bevorzugt solche mit Gruppierung $A^1$-D-$A^2$ wie ebenfalls voranstehend definiert, allein oder in Mischung. Der gewählte Plastifizierer bzw. die gewählte Plastifiziermischung sollte bei der Verarbeitungstemperatur flüssig sein.

Die erfindungsgemäßen Folien sind in ihrer Dicke nicht im besonderen beschränkt; der Fachmann wird die der Anwendung gemäße Dicke jeweils entsprechend auswählen. Geeignet sind beispielsweise Dicken von etwa 10 μm, stärker bevorzugt von etwa 50 μm, bis etwa 1 bis 2 mm und gegebenenfalls auch darüber (z.B. bis ca. 10 mm, wobei derartige Folien auch vorgesehen sein können, um kleindimensionierte Formen daraus auszustanzen, z.B. für Batterien und Akkumulatoren zur Verwendung in der Medizin wie Hörgerätebatterien). Folien zur Herstellung von elektrochemischen Bauelementen in der sogenannten "Dickschicht-Technologie" weisen bevorzugt eine Dicke im Bereich von etwa 50 μm bis 500 μm, ganz besonders bevorzugt im Bereich von etwa 100-200 μm auf. Es ist erfindungsgemäß allerdings auch möglich, entsprechende Dünnschicht-Bauelemente herzustellen (dieser Begriff umfaßt Dicken von vorzugsweise 100 nm bis zu einigen μm). Diese Anwendung dürfte aber beschränkt sein, da entsprechende Bauelemente den gängigen Kapazitätanforderungen in einer Vielzahl von Fällen nicht genügen dürften. Denkbar ist allerdings die Anwendung beispielsweise für Backup-Chips.

Die vorliegende Erfindung betrifft weiterhin Schichtverbünde mit elektrochemischen Eigenschaften, wie insbesondere wiederaufladbare Akkumulatoren und andere Batterien oder elektrochrome Bauelemente, die durch eine entsprechende Abfolge der obengenannten Schichten gebildet werden oder diese umfassen.

Für die Herstellung von Schichtverbünden können die einzelnen pastösen Massen Lage für Lage aufeinander mittels Pastenauftragsverfahren aufgebracht werden. Dabei kann entweder jede einzelne Lage für sich vernetzt oder von Lösungsmittel befreit oder auf sonstige Weise in die Schichtform gebracht werden; es kann aber auch eine Verfestigung der einzelnen Matrices durch Vernetzung oder Abdampfen des Lösungs- oder Quellmittels oder dergleichen nach Beendigung des Auftragens aller benötigten Schichten vorgenommen werden. Letzteres ist beispielsweise dann vorteilhaft, wenn die einzelnen elektrochemisch aktivierbaren Schichten mit einem Druckverfahren aufgetragen werden, das analog zu einem Vielfarbendruck erfolgt. Als Beispiel hierfür sei die Flexodruck-Technik erwähnt, mit deren Hilfe kontinuierlich mehrere Meter/Sekunde eines Substrats mit den erforderlichen elektrochemisch aktivierbaren Schichten bedruckt werden können.

Alternativ kann jede Schicht oder Folie einzeln in ihren endverfestigten Zustand überführt werden. Handelt es sich um selbsttragende Folien, so können die entsprechenden Bestandteile des zu bildenden Bauelementes getrennt z.B. als gerollte Folien aufbewahrt und anschließend durch Laminierung miteinander verbunden werden. Hierfür können konventionelle Laminiertechniken eingesetzt werden. Genannt sei hier beispielsweise das Extrusionsbeschichten, wobei die zweite Schicht durch Anpreßwalzen mit einer Trägerschicht verbunden wird, Kalanderbeschichten mit zwei oder drei Walzspalten, worin neben der pastösen Masse die Trägerbahn mit einläuft, oder Doublieren (Verbinden unter Druck und Gegendruck von bevorzugt erhitzten Walzen). Der Fachmann wird die entsprechenden Techniken ohne weiteres auffinden, die sich durch die Wahl der Matrices für die jeweiligen pastösen Massen ergeben oder anbieten.

Die vorliegenden, erfindungsgemäßen pastösen Massen und daraus hergestellten Folien oder Schichten eignen sich, wie bereits erwähnt, für eine Vielzahl elektrochemischer Bauelemente. Der Fachmann kann hierfür dieselben Festsubstanzen (B) auswählen, die er für klassische elektrochemische Bauelemente, d.h. solche ohne den Zusatz von Kunststoffen, verwenden würde.

Insbesondere für Lithiumsysteme, die die höchsten praktischen volumetrischen sowie gravimetrischen Energiedichten liefern können, ist man aufgrund der Notwendigkeit der Schaffung großer Kontaktoberflächen zur Kompensation der gegenüber wäßrigen Systemen um drei Größenordnungen geringeren ionischen Leitfähigkeit auf Folien angewiesen. Märkte mit hohen Stückzahlen in Millionen wie der 3C-Markt fordern ein Endlosherstellungsverfahren über Folien von der Rolle, da sonst die benötigten Taktzeiten unerreichbar werden.

Nachstehend soll beispielhaft eine Reihe derartiger Lithiumsysteme genannt werden:

- untere Ableitelektrode Al, Cu, Pt, Au, C
- positive Elektrode alle möglichen Kombinationen und multinären Verbindungen von Lithiumcobalt-Lithiumnickel- und Lithiummanganoxiden, ggf. substituiert mit Magnesium, Aluminium oder Fluor
- Elektrolyt $Li_{1,3}Al_{0,3}Ti_{1,7}(PO_4)_3$, $LiTaO_3 \cdot SrTiO_3$, $LiTi_2(PO_4)_3 \cdot Li_2O$, $Li_4SiO_4 \cdot Li_3PO_4$,
- Negative Elektrode Kohlenstoff (in beliebiger Modifikation), $TiO_2$, $TiS_2$ $WO_2$, $MoO_2$ Lithiumtitanat, ein lithiumlegierbares Metall, Oxid, Iodid, Sulfid oder Nitrid , ein lithiumlegierbarer Halbleiter und heterogene Mischungen hiervon
- obere Ableitelektrode Al, Cu, Mo, W, Ti, V, Cr, Ni

Anwendungsbeispiele sind Lithiumzellen, Lithiumpolymerzellen, Lithiumplastikzellen, Lithiumfestkörperzellen oder Lithiumionenzellen.

Die vorliegende Erfindung ist aber selbstverständlich nicht auf Akkumulatoren in Lithiumtechnologie beschränkt, sondern umfaßt, wie bereits oben erwähnt, alle diejenigen Systeme, die sich auch "konventioneller" Technik, d.h. ohne Einarbeiten einer organischen Polymermatrix, herstellen lassen.

Nachstehend sollen einige spezielle Ausgestaltungen der pastösen Massen beschrieben werden, die sich für spezielle Bauelemente oder Bauelement-Bestandteile eignen Soweit die darin eingesetzten elektrochemisch aktivierbaren Bestandteile noch nicht Stand der Technik sind, sollte klar sein, daß diese Substanzen auch in "Bulk-Form", d.h. ohne Polymermatrix, in entsprechenden elektrochemischen Bauelementen eingesetzt werden können.

Durch geeignete Wahl der elektrochemisch aktiven Substanzen lassen sich elektrochemische Bauelemente, beispielsweise Akkumulatoren herstellen, die in den Lade-/Entladekurven Charakteristika aufweisen, mittels derer eine gezielte Kontroile von Be- und Entladezustand des Akkumulators möglich ist. So können als elektrochemisch aktivierbare Festsubstanz (B) für die positive oder die negative Elektrode Mischungen zweier der voranstehend erwähnten Elektrodenmaterialien oder entsprechender anderer Elektrodenmaterialien eingesetzt werden, die unterschiedliche Oxidations-/Reduktionsstufen besitzen. Eine der beiden Substanzen kann alternativ durch Kohlenstoff ersetzt sein. Dies führt zu charakteristischen Verläufen der Be- und Entladekurven, die eine vorteilhafte Detektion des Be- bzw. Entladezustandes eines unter Verwendung solcher Massen hergestellten Akkumulators ermöglichen. Die Kurven weisen dabei zwei verschiedene Plateaus auf. Wird das dem Entladezustand nähere Plateau erreicht, kann dieser Zustand dem Benutzer angezeigt werden, so daß er weiß, daß er bald eine Wiederaufladung vornehmen muß, und vice versa.

Wird in eine für eine negative Elektrode vorgesehen pastöse Masse Kohlenstoff und ein mit Lithium legierbares Element eingearbeitet, so verleiht dies der daraus herstellbaren Elektrode (mit Eigenschaften einer Legierungs- und

einer Interkalationselektrode) eine besonders hohe Kapazität bei verbesserter elektrochemischer Stabilität. Außerdem ist die Volumenausdehnung geringer als bei einer reinen Interkalationselektrode.

Wenn die pastöse Masse der vorliegenden Erfindung für eine Elektrode vorgesehen ist, kann vorgesehen sein, daß zusätzlich ein Leitfähigkeitsverbesserer zugesetzt wird. Hierfür eignen sich Graphit oder amorpher Kohlenstoff (Ruß) bzw. eine Mischung aus beidem, aber auch ein Metallpulver oder ein Nitrid. Insbesondere sind hier Gewichtsanteile von etwa 2,5 bis etwa 35 Gewichts-% amorphem Kohlenstoff, bezogen auf die elektrochemisch aktivierbare Komponente, vorteilhaft. Ist die Masse für eine positive Elektrode vorgesehen, so ist als vorteilhafte Eigenschaft die Schmierwirkung des Kohlenstoffs zu erwähnen, die die mechanische Flexibilität einer aus der pastösen Masse erzeugten Schicht verbessert. Ist die Masse für eine negative Elektrode vorgesehen, so wird zusätzlich die elektrochemische Stabilität und die elektronische Leitfähigkeit verbessert, wie bereits voranstehend beschrieben.

Die erfindungsgemäße pastöse Masse kann auch für andere Elektroden als Interkalationselektroden verwendet werden. Ein Beispiel hierfür ist der Einsatz von Metallpulver in Kombination mit einem Alkali- oder Erdalkalisalz als elektrochemisch aktivierbare Festsubstanz (B). Eine hiermit erzeugte pastöse Masse kann für die Herstellung von Zersetzungselektroden dienen. Damit entfällt die für Interkalaktionselektroden typische Volumenausdehnung, was zu einer verbesserten Alterungsbeständigkeit führt. Als Beispiel hierfür sei die Kombination Kupfer plus Lithiumsulfat genannt.

Überraschenderweise hat sich auch gezeigt, daß die Einarbeitung eines Phasengemischs aus $Li_4SiO_4 \cdot Li_3PO_4$ in die erfindungsgemäße pastöse Masse, unabhängig von deren vorgesehenem elektrochemischem Verwendungszweck, zu einer Verbesserung der Plastizität der daraus erzeugten Elektroden oder Festelektrolyte führt. Voraussetzung hierfür ist, daß das Phasengemisch äußerst fein gemahlen ist. Die extrem geringen Korngrößen dürften die Ursache für eine verbesserte innere Gleitwirkung sein.

Unabhängig davon, ob die Festsubstanz (B) ein Elektrodenmaterial oder ein Elektrolytmaterial ist, kann es aus einem Lithiumionenleiter und einem oder mehreren weiteren Ionenleitern (Li, Cu, Ag, Mg, F, Cl, H) bestehen. Hiermit hergestellte Elektroden und Elektrolyt-Schichten weisen besonders günstige elektrochemische Eigenschaften wie Kapazität, Energiedichte, mechanische und elektrochemische Stabilität auf.

Die vorstehend beschriebenen Bestandteile, aus denen die erfindungsgemäße pastöse Masse hergestellt wird, können auf konventionelle Art und Weise vermischt werden, vorzugsweise durch heftiges Rühren oder Verkneten der Bestandteile. Bevorzugt werden das organische Polymer oder seine Vorstufen mit dem Plastifizierer in einem Lösungs- oder Quellmittel vorgelöst oder vorgequollen, bevor die Komponente (B) zugegeben wird.

Durch das Einbetten der Festsubstanzen (B) in die Matrix (A) entfällt das Sintern der Pulver der elektrochemisch aktivierbaren Substanzen bei hohen Temperaturen, wie es für "konventionelle" elektrochemische Bauelemente üblich ist. Ein solches Sintern würde keine pastöse Konsistenz der Ausgangssubstanzen liefern.

Die elektrochemischen Bauteile, die mit den erfindungsgemäßen pastösen Massen herstellbar sind, sind nicht beschränkt. Die nachstehend beschriebenen Ausgestaltungen sind daher nur als Beispiele oder besonders bevorzugte Ausgestaltungen zu verstehen.

So können wiederaufladbare elektrochemische Zellen in Dickschichttechnologie hergestellt werden, d.h. mit einzelnen, elektrochemisch aktivierbaren Schichten in einer Dicke von etwa 10 μm bis etwa 1 bis 2 mm und bevorzugt von etwa 100-200 μm. Wenn die elektrochemische Zelle auf der Lithiumtechnologie basieren soll, bieten sich als Festsubstanzen für die jeweiligen Elektroden bzw. Elektrolytschichten diejenigen Substanzen an, die bereits voranstehend hierfür aufgezählt sind. Dabei sind mindestens drei Schichten vorzusehen, nämlich eine solche, die als positive Elektrode fungiert, eine, die als Festkörperelektrolyt fungiert, und eine, die als negative Elektrode fungiert.

Erfindungsgemäß hat sich herausgestellt, daß besonders vorteilhafte Stromdichten im Akkumulator erzielt werden, wenn gewisse Grenzbedingungen eingehalten werden. Die Stromdichte läßt sich bekanntlich durch den Widerstand des Elektrolyten einstellen. Ist sie zu hoch gewählt, so können die Elektroden durch Polarisation langfristig zerstört werden; ist sie zu niedrig, so ist die Leistung des hergestellten Akkumulators nur für wenige Einsatzgebiete ausreichend. Die genannte Grenzbedingung liegt vorzugsweise bei 1 $mA/cm^2$. Wenn beispielsweise ein Elektrolyt eine Leitfähigkeit von $10^{-4}$ S/cm besitzt, so ist es besonders vorteilhaft, wenn die Elektrolytschicht etwa 100 μm dick ist. Eine Stromdichte von 1 $mA/cm^2$ ruft dann nämlich einen durch den Widerstand bedingten Spannungsabfall von vernachlässigbaren 0,1 V hervor. Wenn die Leitfähigkeit des Elektrolyten dagegen beispielsweise $10^{-5}$ S/cm beträgt, kann die Dicke der Elektrolytschicht auf etwa 10 μm gesenkt werden. Es ist daher empfehlenswert, die Schichtdicke d im Verhältnis zur Leitfähigkeit $\sigma_{ion}$ und einem ionischen Widerstand (Ω) und in Bezug auf die Fläche A so zu wählen, daß die folgende Formel erfüllt wird:

$$200\ \Omega < d/(\sigma_{ion} \cdot A).$$

Die genannte dreischichtige Zelle (oder jedes beliebige andere elektrochemische Bauelement, bestehend aus positiver Elektrode/Elektrolyt/negativer Elektrode) kann zusätzlich mit Ableitelektroden versehen sein. Diese bestehen zweckmäßigerweise aus Folien der geeigneten Materialien (Materialien für Ableitelektroden, die in der Lithiumtechnologie verwendet werden können, sind weiter vorne beschrieben).

In einer speziellen Ausgestaltung der Erfindung wird zwischen die untere Ableitelektrode und die ihr benachbarte Elektrode sowie die obere Ableitelektrode und die ihr benachbarte Elektrode eine weitere dünne Kunststoffschicht ("Zwischentape") eingearbeitet, die ebenfalls mit Hilfe einer pastösen Masse der vorliegenden Erfindung hergestellt sein kann. Diese dünne Kunststoffschicht sollte leitende, metallische Elemente oder Legierungen aus solchen Elementen enthalten, die geeignet sind, Elektronen vom jeweiligen Elektrodenmaterial auf die jeweilige Ableitelektrode zu transportieren. Beispiele hierfür sind die Elemente Gold, Platin, Rhodium und Kohlenstoff oder Legierungen aus diesen Elementen, wenn die Kunststoffschicht zwischen positiver Elektrode und zugehöriger Ableitelektrode angeordnet werden soll. Wenn sie zwischen negativer Elektrode und Ableitelektrode angeordnet werden soll, sind als Elemente Nickel, Eisen, Chrom, Titan, Molybdän, Wolfram, Vanadium, Mangan, Niob, Tantal, Kobalt oder Kohlenstoff zu nennen. Für die Konzentration und den Aufbau der pastösen Massen, aus denen diese Schichten gebildet werden, gilt das voranstehend für die Elektroden und Elektrolyte Gesagte selbstverständlich ebenfalls.

Die elektrochemischen Bauelemente der vorliegenden Erfindung können beispielsweise in einem kunststoffbasierten Gehäuse, vorzugsweise einer kunststoffbeschichteten Aluminiumfolie, versiegelt werden. Gegenüber Metallgehäusen wird hier das Gewicht vorteilhaft verringert; Vorteile ergeben sich weiterhin für die Energiedichte.

Der elektrochemische Schichtverbund (das elektrochemische Bauelement) kann auch zwischen zwei oder mehr Folien aus einem mit Wachs oder Paraffin beschichteten Kunststoff eingebettet werden. Diese Materialien wirken als Versiegelung und können zusätzlich aufgrund ihrer inhärenten Eigenschaften mechanischen Druck auf den Schichtverbund ausüben, wodurch in vorteilhafter Weise eine Kontaktverbesserung im Schichtverbund durch Preßwirkung erzielt wird.

Während das elektrochemische Bauelement wie vorstehend oder auf andere Weise versiegelt wird, kann man das Innere mit einem vorgegebenen Wasser-/Sauerstoff-Partialdruck beaufschlagen, der eine hohe elektrochemische Stabilität bewirkt. Dies läßt sich beispielsweise durch das Versiegeln des elektrochemischen Elementes in einer solchen Umgebung mit entsprechend eingestellten und gewählten Parametern bewirken.

In einer anderen Ausgestaltung der vorliegenden Erfindung wird als Elektrolytschicht eine Schicht gewählt, die aus zwei miteinander laminierten Folien unterschiedlicher Zusammensetzung besteht, die jeweils an die Elektrode angepaßt sind, mit der sie Kontakt haben. Dies wirkt sich vorteilhaft auf die Stabilität der Phasengrenzen zwischen positiver Elektrode und Elektrolyt 1 sowie negativer Elektrode und Elektrolyt 2 aus. Als konkretes Beispiel für diese Ausgestaltung sei die Verwendung von Lithiumjodid als Elektrolytmaterial der ersten Schicht und $Li_{1,3}Al_{0,3}Ti_{1,7}(PO_4)_3$ als Elektrolytmaterial der zweiten Schicht aus.

Als Beispiel für eine galvanische Zelle mit elektrochromen Eigenschaften sei eine Schichtenfolge genannt, die aus der folgenden Sequenz besteht:

Leiter 1/Y/MeX-Alkoholat/$WO_3$/Leiter 2.

In dieser Sequenz kann das Metall Me z.B. unter Lithium, Natrium, Kalium, Rubidium und Cäsium ausgewählt werden, dessen Anion X z.B. unter den Halogeniden Chlorid, Bromid und Jodid. Der Leiter 1 kann z.B. ausgewählt sein unter Indium-Zinn-Oxid (ITO), Zink-Aluminium-Oxid ($Zn_xAl_yO_z$) und Silber. Der Leiter 2 kann z.B. ausgewählt sein unter Indium-Zinn-Oxid (ITO) und Zink-Aluminium-Oxid ($Zn_xAl_yO_z$).

Die erfindungsgemäßen Schichtfolgen der elektrochemischen Bauelemente können in beliebiger Form angeordnet werden. Beispielsweise können die flexiblen Schichtverbünde aufgerollt werden, wodurch eine besonders vorteilhafte Geometrie für kompakte Akkumulatoren erzielt wird. Bei kleinem Bauvolumen des Akkumulators ist hier eine sehr große batterieaktive Fläche vorhanden.

Nicht-selbsttragende Schichtverbünde können auch auf festen Untergründen wie Wänden zur integrierten Energiespeicherung aufgetragen werden (selbsttragende Folienverbände können natürlich ebenfalls aufgebracht bzw. aufgeklebt werden). Hier können große Flächen ausgenutzt werden; ein eigener Raumbedarf für die Akkumulatoren ist nicht gegeben. Ein spezielles Beispiel für eine derartige Ausgestaltung ist die Integration von Schichtverbünden für Akkumulatoren in Substrate für Solarzellen. Hierdurch können autarke Energieversorgungseinheiten geschaffen werden. Schichtsequenzen für Akkumulatoren können auch auf feste oder flexible Substrate aufgebracht werden, um in elektronischen Aufbauten der integrierten Energiespeicherung zu dienen.

Nachstehend sollen konkrete Beispiele die Erfindung näher erläutern:

Beispiel 1

Eine Batteriefolie (negative Elektrode) wird hergestellt, indem 5 g fein pulverisiertes $Li_4Ti_5O_{12}$, 1,0 g Acetylenruß

(Batteriequalität), 0,5 g Ethylencarbonat mit 1,25 g Polyvinylidenfluorid-Hexafluorpropylen in ca. 50 g Aceton mindestens 4 h entweder mit einem Magnetrührer oder einem Dissolver gerührt werden. Die Mischung wird dabei zunächst auf 100°C erhitzt, nach Erreichen dieser Temperatur auf 50°C abgekühlt und sodann bei dieser Temperatur gehalten. Nach Ende der Rührzeit wird auf Gieß- bzw. Rakelfähigkeit eingedickt, und die Folie wird mit einer Tape-Casting Anlage ausgezogen. Der Rakelschlitz ist dabei so gewählt, daß nach dem Trocknen eine Foliendicke von 150-200 μm erreicht wird. Die Folie wird über Nacht bei 70°C und 1 mbar Enddruck in einem Vakuumtrockenschrank getrocknet.

Beispiel 2

Eine Batteriefolie (Elektrolyt) entsteht aus 9 g fein pulverisiertem $LiAlSi_2O_6$ (Spodumen), 0,9 g Ethylencarbonat, 3,0 g Polyvinylidenfluorid-Hexafluorpropylen, aufbereitet in ca. 30 g Aceton wie die negative Elektrode und ausgezogen auf eine Dicke von 70-100 μm.

Beispiel 3

Eine Batteriefolie (positive Elektrode) entsteht aus 8 g fein pulverisiertem $LiCoO_2$, 1,2 g Acetylenruß (Batteriequalität), 0,8 g Ethylencarbonat, 2,0 g Polyvinylidenfluorid-Hexafluorpropylen und ca. 30 g Aceton wie die negative Elektrode.

In allen Folien sollte die Reinheit der Ausgangsmaterialien 99% nicht wesentlich unterschreiten.

Nach Zurechtschneiden werden die einzelnen Folien gemäß Tabelle 2 zu einer kompletten Einzelzelle laminiert.

Tabelle 2

| Schritt | | Folien | Temperatur | Kraft auf 6x3 $cm^2$ | Haltezeit |
|---|---|---|---|---|---|
| 1a | Lamination auf Cu-Netz | Negative Elektrode $Li_4Ti_5O_{12}$ | 150°C | 15 kN | 20 sec |
| 1b | Lamination auf Al-Netz | Positive Elektrode $LiCoO_2$ | 150°C | 10 kN | 10 sec |
| 2 | Lamination Elektrolyt auf neg. Elektrode | Elektrolyt $LiAlSi_2O_6$ (Spodumen) +neg. Elektrode | 130°C | 4 kN | 60 sec |
| 3 | Symmetr. Lamination von 2 pos. Elektroden auf Laminat aus Schritt 2 | Pos. Elektroden +Laminat aus 2 | 130°C | 4 kN | 60 sec |

Insgesamt sind 4 Laminationsschritte aus Gründen des Wärmeeintrags besonders vorteilhaft, 1a und 1b sind von der Reihenfolge her austauschbar, bei 2 und 3 wurde die Zeitdauer für die Laminierung im Vergleich zu 1a und 1b gesteigert, da der Elektrolyt Wärme weitaus schlechter leitet als die Elektroden. Die Netze, auf die die Elektroden in den Schritten 1a und 1b laminiert werden, sind mit einem Ruß+Polymergemisch vorbehandelt. Die Flexibilität bleibt dabei erhalten.

Die Qualität der Lamination ist sehr hoch, weder Blasen noch Dekontaktierungen konnten beobachtet werden.

Die fertige Zelle wird in einer asymmetrisch mit Kunststoff beschichteten 60 μm dicken Aluminiumfolie teilverschweißt, die Netze werden dabei über zwei Kontaktzungen herausgeführt. Anschließend wird die Zelle mit einem zweiten Festelektrolyten, der in einer einziehbaren Lösung (0.66 mol/l $LiBF_4$ in einer Mischung aus Ethylencarbonat und Dimethylcarbonat im Gewichtsverhältnis von 2:1) zugegeben wird, aktiviert und dann dichtverschweißt.

Das Lithiumtitanat, $Li_4Ti_5O_{12}$, wurde als Kandidat für die negative Elektrode gewählt, da das feine, weiß/weißgraue Pulver zunächst ein ionischer und elektronischer Isolator ist und somit eine große Herausforderung darstellt. Eine Anbindung an die Körnchenoberflächen des Lithiumtitanats und die damit verbundene Fähigkeit der Zelle zum Zykeln ist nur bei einer optimalen heterogenen Folie, die über den Acetylenruß die elektronische Leitfähigkeit und einen zweiten Elektrolyten die ionische Leitfähigkeit erhält, möglich.

Die Abbildungen 1-3 zeigen die Zykeldaten dreier Zellen, die nach dem beschriebenen Verfahren hergestellt worden sind. Die Reproduzierbarkeit als Funktion der Schichtdicke und der Qualität der Folien sowie des Laminationsprozesses ist hoch.

Ein ganz wesentliches Ergebnis ist das Erreichen eines Ladefaktors von praktisch 1. Dieser Faktor beschreibt das Verhältnis zwischen eingebrachter und entnehmbarer Ladung. Eins bedeutet, daß die Zelle keine Selbstentladung besitzt. Ni-Cd oder Ni-MeH Zellen liegen zum Vergleich bei 1,6. Ebenso läßt sich mit bloßem Auge aus den Kurven entnehmen, daß die Zellen stabil zykeln, d.h., keinen bzw. nur äußerst minimalen Verlusten der mit jedem folgenden Laden und Entladen absolut einbring- und entnehmbaren Ladung unterliegen. Eine maximale Anzahl von Ladezykeln ist zu diesem Zeitpunkt noch nicht nennbar, da auch nach mehreren hundert Zykeln noch keine Degeneration eingetreten ist und Langzeitmessungen auf mehrere 100 Zykeln leicht 1 Jahr überschreiten können.

## Patentansprüche

**1.** In elektrochemischen Bauelementen verwendbare, pastöse Masse, umfassend eine heterogene Mischung aus

(1.) einer mindestens ein organisches Polymer, dessen Vorstufen oder dessen Präpolymere sowie einen Plastifizierer enthaltenden oder aus den genannten Bestandteilen bestehenden Matrix (A) und
(2.) einem in der Matrix und in Wasser nicht löslichen, ionenleitenden oder elektronenleitenden anorganischen Material in Form einer Festsubstanz (B), das sich als Elektrodenmaterial oder Festelektrolyt eignet,

mit der Maßgabe, daß ein im Plastifizierer löslicher, von (B) verschiedener Leiter in der Mischung nicht vorhanden ist, **dadurch gekennzeichnet, daß** der Plastifizierer in einem Anteil von bis zu 5 Gew.-% vorliegt, bezogen auf die Menge des elektrochemisch aktivierbaren Materials.

**2.** Pastöse Masse nach Anspruch 1, **dadurch gekennzeichnet, daß** der Plastifizierer ausgewählt ist unter Substanzen, die die Gruppierung

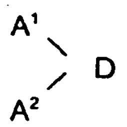

tragen, wobei $A^1$ und $A^2$ unabhängig voneinander $R^1$, $OR^1$, SR' oder $NHR^1$ mit $R^1$ gleich $C_1$-$C_6$-Alkyl bedeuten können oder $A^1$ und $A^2$ mit D zusammen einen Hetero-5-Ring ausbilden und D C=O, S=O, C=NH oder $C=CH_2$ bedeuten kann und außerdem dann, wenn D mit $A^1$ und $A^2$ einen Hetero-5-Ring bildet, auch O, S, NH oder $CH_2$ bedeuten kann.

**3.** Pastöse Masse nach Anspruch 2, **dadurch gekennzeichnet, daß** A1 und A2 unabhängig voneinander aus den Gruppen O, $CHR^2$, NH oder S gebildet sind, wobei $R^2$ Wasserstoff, Methyl oder Ethyl ist, und mit D zusammen einen Hetero-5-Ring bilden und insbesondere, daß $A^1$ und $A^2$ zusammen $-E^1-CHR^2-CHR^2-E^2-$ sind, worin $E^1$ und $E^2$ gleich oder verschieden sind und S, O, NH oder $CHR^2$ bedeuten.

**4.** Pastöse Masse nach einem der Ansprüche 2 oder 3, worin der Plastifizierer ausgewählt ist unter Dimethylsulfoxid, Dimethylcarbonat, Ethylmethylcarbonat, Diethylcarbonat, Methylpropylcarbonat, Ethylencarbonat, Ethylensulfit, Propylencarbonat, Dioxolan, Tetrahydrofuran, γ-Butyrolacton oder einer Mischung hiervon.

**5.** Pastöse Masse nach einem der voranstehenden Ansprüche, **dadurch gekennzeichnet, daß** das organische Polymer der Matrix (A) ein halogeniertes, stärker bevorzugt ein fluoriertes Polymer ist und ganz bevorzugt ein Polyvinylidenfluorid-Hexafluorpropylen-Copolymeres ist.

**6.** Pastöse Masse nach einem der voranstehenden Ansprüche, **dadurch gekennzeichnet, daß** die Matrix (A) weiterhin ein Lösungs- oder Quellmittel für das organische Polymer, dessen Vorstufen oder dessen Präpolymere enthält.

**7.** Pastöse Masse nach einem der voranstehenden Ansprüche, **dadurch gekennzeichnet, daß** das elektrochemisch aktivierbare Material (B) ausgewählt ist unter Substanzen, die sich als positives Elektrodenmaterial eignen oder Substanzen, die sich als negatives Elektrodenmaterial eignen oder Substanzen, die sich als Festkörperelektrolyte eignen oder Substanzen, die sich als elektrochrom aktive Elektrodenmaterialien eignen oder Substanzen, die sich als ionische oder elektronische Zwischenleiter zwischen zwei in einem elektrochemischen Bauelement benachbart anordbaren solchen Substanzen oder Materialien eignen.

**8.** Selbsttragende oder auf einem Substrat aufliegende Schicht, umfassend eine heterogene Mischung aus

(1.) einer mindestens ein organisches Polymer sowie einen Plastifizierer enthaltenden oder aus den genannten Bestandteilen bestehenden Matrix (A) wie in einem der Ansprüche 1 bis 6 definiert und
(2.) einem in der Matrix nicht löslichen, ionenleitenden oder elektronenleitenden anorganischen Material in Form einer Festsubstanz (B), das sich als Elektrodenmaterial oder Festelektrolyt eignet,wie in einem der Ansprüche 1 oder 7 definiert, sowie ggf.
(3.) einen Leitfähigkeitsverbesserer (C).

**9.** Selbsttragende oder auf einem Substrat aufliegende Schicht nach Anspruch 8, **dadurch gekennzeichnet, daß** die Schicht eine flexible Folie ist.

**10.** Selbsttragende oder auf einem Substrat aufliegende Schicht nach Anspruch 8 oder Anspruch 9, **dadurch gekennzeichnet, daß** sie zusätzlich einen Elektrolyten enthält, der in gelöster Form in die Schicht eingebracht wurde.

**11.** Schichtverbund mit elektrochemischen Eigenschaften, umfassend

(1.) eine Schicht gemäß einem der Ansprüche 8 bis 10, worin das anorganische Material (B) unter solchen Substanzen ausgewählt ist, die elektronenleitend und als Materialien für positive Elektroden geeignet sind, und/oder
(2.) eine Schicht gemäß einem der Ansprüche 8 bis 10, worin das anorganische Material (B)ausgewählt ist unter ionenleitenden Substanzen mit Festkörperelektrolyt-Eigenschaften, und/oder
(3.) eine Schicht gemäß einem der Ansprüche 8 bis 10, worin das anorganische Material (B) unter solchen Substanzen ausgewählt ist, die elektronenleitend und als Materialien für negative Elektroden geeignet sind.

**12.** Wiederaufladbare, elektrochemische Zelle in Dickschichttechnologie, umfassend einen Schichtverbund mit elektrochemischen Eigenschaften nach Anspruch 11.

**13.** Wiederaufladbare elektrochemische Zelle nach Anspruch 12, **dadurch gekennzeichnet, daß** das elektrochemisch aktivierbare Material für die positive Elektrode ausgewählt ist unter Lithiumcobaltoxid, Lithiumnickeloxid, Nickelmanganoxid, allein oder in Mischung oder als multinäre Verbindung und/oder substituiert mit Magnesium, Aluminium oder Fluor, und/oder worin das elektrochemisch aktivierbare Material für den Elektrolyten ausgewählt ist unter in der Natur vorkommenden Lithiumsalzen und -mineralien, bevorzugt Spodumen, β-Eukryptit und Petalit, und synthetischen Lithiumsalzen, bevorzugt solchen, die weitere Kationen, ausgewählt unter solchen der Haupt- und Nebengruppenelemente, enthalten, und/oder worin das elektrochemisch aktivierbare Material für die negative Elektrode ausgewählt ist unter einer beliebigen Kohlenstoffmodifikation, Titandioxid, Titandisulfid, Wolframdioxid, Molybdändioxid, Lithiumtitanat, einem lithiumlegierbaren Metall, Halbleitermaterialien, Oxiden, Iodiden, Sulfiden, Nitriden oder heterogenen Mischungen hiervon.

**14.** Wiederaufladbare elektrochemische Zelle nach einem der Ansprüche 12 oder 13, **dadurch gekennzeichnet, daß** sie eine Schicht (1.), eine Schicht (2.) und eine Schicht (3.) wie im Anspruch 11 definiert aufweist und mindestens Schicht (2.) zusätzlich einen Elektrolyten enthält, der in gelöster Form in die Schicht(en) eingebracht wurde.

**15.** Wiederaufladbare elektrochemische Zelle nach einem der Ansprüche 12 bis 14, **dadurch gekennzeichnet, daß** die darin enthaltenen Schichten oder Folien Stabilitätsfenster im Bereich zwischen 0-3 Volt bis 0-5 Volt, vorzugsweise 0-4,5 Volt gegenüber Lithium aufweisen.

**16.** Verfahren zum Herstellen einer flexiblen Folie gemäß Anspruch 9, **dadurch gekennzeichnet, daß** eine pastöse Masse nach einem der Ansprüche 1 bis 7 auf einer Unterlage in Schichtform gebracht und die so erhaltene Schicht entweder bei Unterdruck bis zu etwa $10^{-2}$ mbar und einer Temperatur zwischen Umgebungstemperatur bis zu 150°C, vorzugsweise im Bereich von 65-80°C, oder bei Umgebungsdruck bei einer Temperatur von bis zu 200°C, vorzugsweise im Bereich von etwa 120°C, getrocknet wird.

**17.** Verfahren zum Herstellen einer selbsttragenden Schicht nach Anspruch 10, **dadurch gekennzeichnet, daß**

(1.) eine pastöse Masse nach einem der Ansprüche 1 bis 7 in Schichtform gebracht und die so erhaltene Schicht getrocknet wird und
(2.) die getrocknete Schicht mit einem gelösten Elektrolyten derart in Kontakt gebracht wird, daß dieser in die

Schicht eindringt, worauf die Folie bei einer Temperatur im Bereich von etwa 70-90°C getrocknet wird.

**18.** Verfahren zum Herstellen eines Schichtverbundes nach Anspruch 11, **dadurch gekennzeichnet, daß** die jeweils für eine Schicht vorgesehenen pastösen Massen einzeln in die Form einer selbsttragenden Schicht gebracht werden und diese Schichten anschließend laminiert werden, wobei die Laminierung vorzugsweise bei einer Temperatur im Bereich zwischen 5°C oberhalb und unterhalb des Schmelz- bzw. Erweichungspunktes des eingesetzten organischen Polymeren vorgenommen wird.

**19.** Verfahren nach Anspruch 18, **dadurch gekennzeichnet, daß** die Laminierung in einem Temperaturbereich zwischen 100°C und 250°C, vorzugsweise zwischen 135°C und 150°C, erfolgt.

**20.** Verfahren nach einem der Ansprüche 18 oder 19, **dadurch gekennzeichnet, daß** die Laminierung mit einem Mindestdruck von $0{,}5 kg/20 cm^2$ erfolgt.

**21.** Verfahren nach einem der Ansprüche 18 bis 20, **dadurch gekennzeichnet, daß** der laminierte Schichtverbund anschließend mit einem gelösten Elektrolyten derart in Kontakt gebracht wird, daß dieser in den Schichtverbund eindringt, worauf der Schichtverbund bei einer Temperatur im Bereich von etwa 70-90°C getrocknet wird.

## Claims

**1.** Paste-like mass that can be used in electrochemical structural elements, comprising a heterogeneous mixture of

(1.) a matrix (A) containing at least one organic polymer, precursors thereof, or prepolymers thereof, and a plasticizer, or consisting of said components, and
(2.) an ion conducting or electron conducting inorganic material in the form of a solid substance (B), which material is not soluble in said matrix and in water and which is suitable as electrode material or solid electrolyte.

with the proviso that a conductor that is soluble in the plasticizer and that is different from (B) is not present in the mixture, **characterized in that** the plasticizer is present in a proportion of up to 5 % by weight, relative to the quantity of the electrochemically activatable material.

**2.** Paste-like mass in accordance with claim 1, **characterized in that** said plasticizer is selected from among substances carrying the group

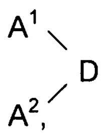

wherein independently of each other $A^1$ and $A^2$ can be $R^1$, $OR^1$, $SR^1$ or $NHR^1$ with $R^1$ being $C_1$-$C_6$ alkyl, or $A^1$ and $A^2$ together with D form a hetero-5-ring, and D can be C=O, S=O, C=NH or $C=CH_2$ and further, if D forms a hetero-5-ring with $A^1$ and $A^2$, D can also mean O, S, NH or $CH_2$.

**3.** Paste-like mass in accordance with claim 2, **characterized in that** independently of each other $A^1$ and $A^2$ consist of the groups O, $CHR^2$, NH or S, wherein $R^2$ is hydrogen, methyl, or ethyl, and form a hetero-5-ring together with D, and particularly that $A^1$ and $A^2$ together are $-E^1-CHR^2-CHR^2-E^2-$, wherein $E^1$ and $E^2$ are identical or different and mean S, O, NH or $CHR^2$.

**4.** Paste-like mass in accordance with any of claims 2 or 3, wherein said plasticizer is selected from among dimethyl sulfoxide, dimethyl carbonate, ethyl methyl carbonate, diethyl carbonate, methyl propyl carbonate, ethylene carbonate, ethylene sulfite, propylene carbonate, dioxolane, tetrahydrofurane, γ-butyrolactone or a mixture of said substances.

**5.** Paste-like mass in accordance with any of the preceding claims, **characterized in that** the organic polymer of matrix (A) is a halogenated polymer, more preferably a fluorinated polymer, and most preferably is a polyvinylidene fluoride hexafluoropropylene copolymer.

6. Paste-like mass in accordance with any of the preceding claims, **characterized in that** said matrix (A) further contains a solvent or swelling agent for said organic polymer, its precursors or its prepolymers.

7. Paste-like mass in accordance with any of the preceding claims, **characterized in that** said electrochemically activatable material (B) is selected from among substances that are suitable as a positive electrode material, or from among substances that are suitable as a negative electrode material, or from among substances that are suitable as solid electrolytes, or from among substances that are suitable as electrochromically active electrode materials, or from among substances that are suitable as ionic or electronic intermediate conductors between two such substances or materials that are arranged adjacent in an electrochemical structural element.

8. Self-supporting layer or layer that is placed on a substrate, comprising a heterogeneous mixture of

   (1.) a matrix (A) containing at least one organic polymer and a plasticizer as defined in any of claims 1 through 6 or consisting of said components, and
   (2.) an ion conducting or electron conducting inorganic material in the form of a solid substance (B), which material is not soluble in said matrix and in water and which is suitable as electrode material or solid electrolyte, and optionally
   (3.) a conductivity improving agent (C).

9. Self-supporting layer or layer that is placed on a substrate in accordance with claim 8, **characterized in that** said layer is a flexible film.

10. Self-supporting layer or layer that is placed on a substrate in accordance with one of claims 8 oder 9, **characterized in that** said layer additionally contains an electrolyte introduced into said layer in a dissolved form.

11. Composite layer having electrochemical properties, comprising

   (1.) a layer in accordance with any of claims 8 through 10, wherein said inorganic material (B) is selected from among substances that are electron-conducting and suitable as materials for positive electrodes, and/or
   (2.) a layer in accordance with any of claims 8 through 10, wherein said inorganic material (B) is selected from among ion-conducting substances having solid electrolyte properties, and/or
   (3.) a layer in accordance with any of claims 8 through 10, wherein said inorganic material (B) is selected from among substances that are electron-conducting and suitable as materials for negative electrodes.

12. Rechargeable electrochemical cell made in thick layer technology, comprising a composite layer having electrochemical properties in accordance with claim 11.

13. Rechargeable electrochemical cell in accordance with claim 12, **characterized in that** the electrochemically activatable material for the positive electrode is selected from among lithium cobalt oxide, lithium nickel oxide, nickel manganese oxide, alone or in mixture or as a multinary compound and/or substituted by magnesium, aluminum or fluorine, and/or wherein said electrochemically activatable material for said electrolyte is selected from among natural salts and minerals of lithium, preferably spodumene, β-eucryptite and petalite, and from among synthetic lithium salts, preferably such containing further cations selected from cations of the principal and auxiliary group elements, and/or wherein the electrochemically activatable material for the negative electrode is selected from among an optional carbon modification, titanium dioxide, titanium disulfide, tungsten dioxide, molybdenum dioxide, lithium titanate, a lithium-alloyable metal, semiconductor materials, oxides, iodides, sulfides, nitrides or heterogeneous mixtures thereof.

14. Rechargeable electrochemical cell in accordance with one of claims 12 or 13, **characterized in that** it comprises a layer (1.), a layer (2.) and a layer (3.) as defined in claim 11, and that at least said layer (2.) additionally contains an electrolyte which has been introduced into said layer(s) in a dissolved form.

15. Rechargeable electrochemical cell in accordance with any of claims 12 through 14, **characterized in that** the layers or films contained therein have stability areas in a range of between 0-3 volt to 0-5 volt, preferably 0-4.5 volt with respect to lithium.

16. Method for producing a flexible film in accordance with claim 9, **characterized in that** a paste-like mass in accordance with any of claims 1 through 7 is applied on a base to have layer form and the layer thus obtained is dried either at

a low pressure of up to substantially $10^{-2}$ mbar and at a temperature between ambient temperature up to 150°C, preferably in a range of 65-80°C, or at ambient pressure at a temperature of up to 200°C, preferably in a range of about 120°C.

**17.** Method for producing a self-supporting layer in accordance with claim 10, **characterized in that**

(1.) a paste-like mass in accordance with any of claims 1 through 7 is adapted to have layer form and the layer thus obtained is dried, and
(2.) said dried layer is brought into contact with a dissolved electrolyte such that said electrolyte penetrates into said layer, whereupon the film is dried at a temperature in the range of substantially 70-90°C.

**18.** Method for producing a composite layer in accordance with claim 11, **characterized in that** the paste-like masses provided for each of the layers are individually adapted to have the form of a self-supporting layer and that said layers are laminated subsequently, wherein said lamination is preferably effected at a temperature in the range of between 5°C above and below the melting or softening point of the organic polymer used.

**19.** Method in accordance with claim 18, **characterized in that** said lamination is effected in a temperature range of between 100°C and 250°C, preferably between 135°C and 150°C.

**20.** Method in accordance with any of claims 18 or 19, **characterized in that** said lamination is effected at a pressure of at least $0.5kg/20cm^2$.

**21.** Method in accordance with any of claims 18 through 20, **characterized in that** the laminated composite layer is subsequently brought into contact with a dissolved electrolyte such that said electrolyte penetrates into said composite layer, whereupon said composite layer is dried at a temperature in the range of substantially 70-90°C.

## Revendications

**1.** Masse pâteuse, utilisable dans des éléments électrochimiques, comprenant un mélange hétérogène constitué :

(1.) d'une matrice (A) comprenant au moins un polymère organique, ses stades antérieurs ou ses prépolymères ainsi qu'un plastifiant ou à base desdits constituants et
(2.) d'un matériau inorganique, non soluble dans la matrice ni dans l'eau, conducteur d'ions ou conducteur d'électrons sous la forme d'une substance solide (B), qui convient comme matériau d'électrode ou électrolyte solide,

à condition qu'un conducteur soluble dans le plastifiant différent de (B) ne soit pas présent dans le mélange, **caractérisée en ce que** le plastifiant est présent dans une fraction allant jusqu'à 5 % en poids par rapport à la quantité du matériau activable de façon électrochimique.

**2.** Masse pâteuse selon la revendication 1, **caractérisée en ce que** le plastifiant est choisi parmi des substances qui portent le groupement suivant

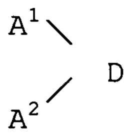

$A^1$ et $A^2$ pouvant signifier indépendamment l'un de l'autre $R^1$, $OR^1$, $SR^1$ ou $NHR^1$ avec $R^1$ égal à alkyle en $C_1$ à $C_6$ ou bien $A^1$ et $A^2$ formant avec D conjointement une hétéro-5-bague et D pouvant signifier C=O, S=O, C=NH ou $C=CH_2$ et pouvant signifier d'autre part également O, S, NH ou $CH_2$ dans les cas où D forme avec $A^1$ et $A^2$ une hétéro-5-bague.

**3.** Masse pâteuse selon la revendication 2, **caractérisée en ce que** A1 et A2 sont formés indépendamment l'un de l'autre par les groupes O, $CHR^2$, NH ou S, $R^2$ étant de l'hydrogène, du méthyle ou de l'éthyle, et formant conjointement avec D une hétéro-5-bague et en particulier en ce que $A^1$ et $A^2$ sont en même temps $-E^1-CHR^2-CHR^2-E^2$, $E^1$ et $E^2$

étant identiques ou différents et signifiant S, O, NH ou $CHR^2$.

**4.** Masse pâteuse selon l'une quelconque des revendications 2 ou 3, le plastifiant étant choisi parmi les éléments suivants : diméthylsulfoxyde, diméthylcarbonate, éthylméthylcarbonate, diéthylcarbonate, méthylpropylcarbonate, carbonate d'éthylène, sulfite d'éthylène, carbonate de propylène, dioxolanne, tétrahydrofuranne, γ-butyrolacton ou un mélange de ces éléments.

**5.** Masse pâteuse selon l'une quelconque des revendications précédentes, **caractérisée en ce que** le polymère organique de la matrice (A) est un polymère halogéné, avec une plus forte préférence un polymère fluoré et avec une préférence toute particulière un copolymère fluorure de polyvinylidène - hexafluorpropylène.

**6.** Masse pâteuse selon l'une quelconque des revendications précédentes, **caractérisée en ce que** la matrice (A) contient également un solvant ou un agent gonflant pour le polymère organique, ses stades préalables ou ses prépolymères.

**7.** Masse pâteuse selon l'une quelconque des revendications précédentes, **caractérisée en ce que** le matériau (B) activable par électrochimie est choisi parmi des substances qui conviennent comme matériau d'électrode positif ou des substances qui conviennent comme matériau d'électrode négatif ou des substances qui conviennent comme électrolytes solides ou comme substances qui conviennent comme matériaux d'électrode actifs avec de l'électrochrome ou des substances qui conviennent en tant que conducteurs intermédiaires ioniques ou électroniques entre deux substances ou matériaux de ce type pouvant être disposés à proximité dans un composant électrochimique.

**8.** Couche autoportante ou reposant sur un substrat, comprenant un mélange hétérogène constitué :

(1.) d'au moins une matrice (A) contenant au moins un polymère organique et un plastifiant ou constituée desdits constituants comme défini dans l'une des revendications 1 à 6 et
(2) d'un matériau inorganique, non soluble dans la matrice, conducteur d'ions ou conducteur d'électrons sous la forme d'une substance dure (B), qui convient comme matériau d'électrode ou électrolyte solide, comme défini dans les deux revendications 1 ou 7, ainsi qu'éventuellement
(3) d'un agent améliorant la conductibilité (C).

**9.** Couche autoportante ou reposant sur un substrat selon la revendication 8, **caractérisée en ce que** la couche est un film flexible.

**10.** Couche autoportante ou reposant sur un substrat selon la revendication 8 ou 9, **caractérisée en ce qu'**elle contient en supplément un électrolyte qui a été introduit sous forme dissoute dans la couche.

**11.** Ensemble de couches présentant des propriétés électrochimiques, comprenant :

(1.) une couche selon l'une quelconque des revendications 8 à 10, dans laquelle le matériau inorganique (B) est choisi parmi des substances qui sont conductrices d'électrons et sont appropriées comme matériaux pour des électrodes positives, et/ou
(2.) une couche selon l'une quelconque des revendications 8 à 10, le matériau (B) inorganique étant choisi parmi des substances conductrices d'ions avec des propriétés d'électrolyte solide, et/ou
(3.) une couche selon l'une quelconque des revendications 8 à 10, dans laquelle le matériau (B) inorganique est choisi parmi des substances qui sont conductrices d'électrons et conviennent comme matériaux pour des électrodes négatives.

**12.** Cellule rechargeable et électrochimique en technologie de couches épaisses, comprenant un ensemble de couches avec des propriétés électrochimiques selon la revendication 11.

**13.** Cellule électrochimique rechargeable selon la revendication 12, **caractérisée en ce que** le matériau activable par électrochimie pour l'électrode positive est choisi entre l'oxyde de cobalt au lithium, l'oxyde de nickel au lithium, l'oxyde de manganèse au nickel, seul ou en mélange ou sous forme de composé multinaire et/ou substitué avec du magnésium, de l'aluminium ou du fluor et/ou dans lequel le matériau activable par électrochimie pour l'électrolyte est choisi parmi des sels et minéraux de lithium se trouvant dans la nature, de préférence Spodumen, β-Eukryptite et pétalite, et des sels de lithium synthétiques, de préférence ceux qui contiennent d'autres cations, sélectionnés parmi ceux des éléments de groupes principaux et des éléments de groupes secondaires, et/ou dans lesquels le

matériau activable au plan électrochimique pour l'électrode négative est choisi entre une modification de carbone quelconque, le dioxyde de titane, le disulfure de titane, le dioxyde de tungstène, le dioxyde de molybdène, le titanate de lithium, un métal pouvant être allié au lithium, des matériaux semi-conducteurs, des oxydes, des iodures, des sulfures, des nitrures ou des mélanges hétérogènes de ces éléments.

**14.** Cellule électrochimique rechargeable selon l'une quelconque des revendications 12 ou 13, **caractérisée en ce qu'**elle présente une couche (1.), une couche (2.) et une couche (3.) comme défini dans la revendication 11, et au moins une couche (2.) contient en supplément un électrolyte qui a été introduit sous forme dissoute dans la (ou les) couche(s).

**15.** Cellule électrochimique rechargeable selon l'une quelconque des revendications 12 à 14, **caractérisée en ce que** les couches ou films contenus à l'intérieur présentent des fenêtres de stabilité dans la zone située entre 0-3 Volts jusqu'à 0-5 Volts, de préférence de 0-4,5 Volts par rapport au lithium.

**16.** Procédé pour la fabrication d'un film flexible selon la revendication 9, **caractérisé en ce qu'**une masse pâteuse selon l'une quelconque des revendications 1 à 7 est amenée sur un support sous forme de couche et la couche ainsi obtenue est séchée soit avec une dépression allant jusqu'à environ $10^{-2}$ mbars et avec une température comprise entre la température ambiante jusqu'à 150°C, de préférence dans la plage de 65 à 80°C, ou à la température ambiante à une température allant jusqu'à 200°C, de préférence dans la plage d'environ 120°C.

**17.** Procédé pour fabriquer une couche autoportante selon la revendication 10,
**caractérisé en ce que** :

(1.) une masse pâteuse selon l'une quelconque des revendications 1 à 7 est amenée sous forme de couche et la couche ainsi obtenue est séchée et
(2.) la couche séchée est amenée en contact avec un électrolyte dissous de telle sorte que cet électrolyte pénètre dans la couche, après quoi le film est séché à une température de l'ordre d'environ 70 à 90°C.

**18.** Procédé pour fabriquer un ensemble de couches selon la revendication 11, **caractérisé en ce que** les masses pâteuses prévues respectivement pour une couche sont amenées individuellement sous la forme d'une couche autoportante et ces couches sont ensuite stratifiées, la stratification étant effectuée de préférence à une température située entre 5°C au-dessus et au-dessous du point de fusion ou du point de ramollissement du polymère organique utilisé.

**19.** Procédé selon la revendication 18, **caractérisé en ce que** la stratification s'effectue dans une plage de température comprise entre 100°C et 250°C, de préférence entre 135°C et 150°C.

**20.** Procédé selon l'une quelconque des revendications 18 ou 19, **caractérisé en ce que** la stratification s'effectue à une pression minimale de 0,5 $kg/20cm^2$.

**21.** Procédé selon l'une quelconque des revendications 18 à 20, **caractérisé en ce que** l'ensemble de couches stratifiées est mis en contact ensuite avec un électrolyte dissous de telle sorte que cet électrolyte pénètre dans l'ensemble de couches, après quoi l'ensemble de couches est séché à une température de l'ordre d'environ 70 à 90°C.

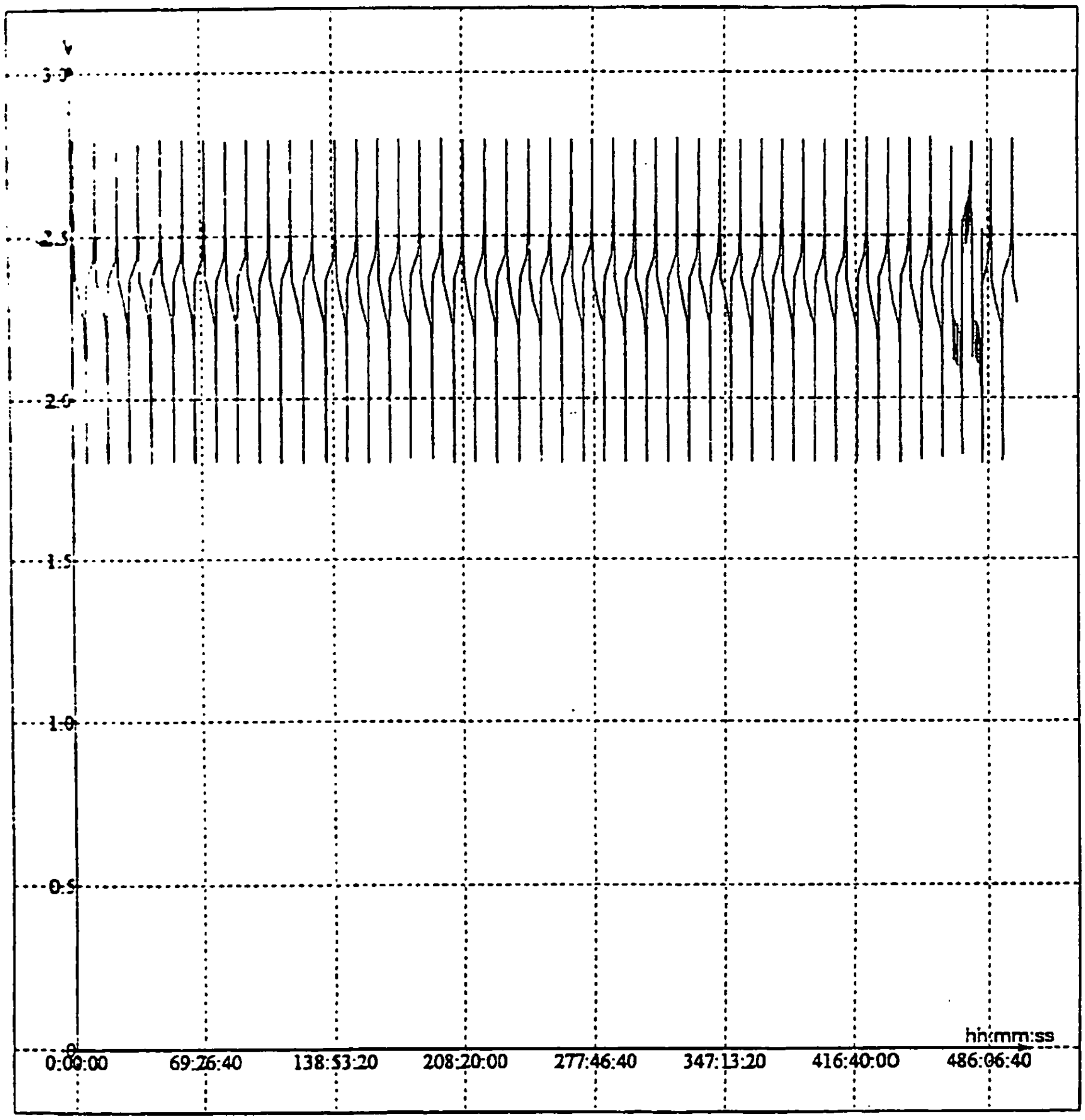
V
3.0
2.5
2.0
1.5
1.0
0.5
0
0:00:00
69:26:40
138:53:20
208:20:00
277:46:40
347:13:20
416:40:00
486:06:40
hh:mm:ss

Fig. 1

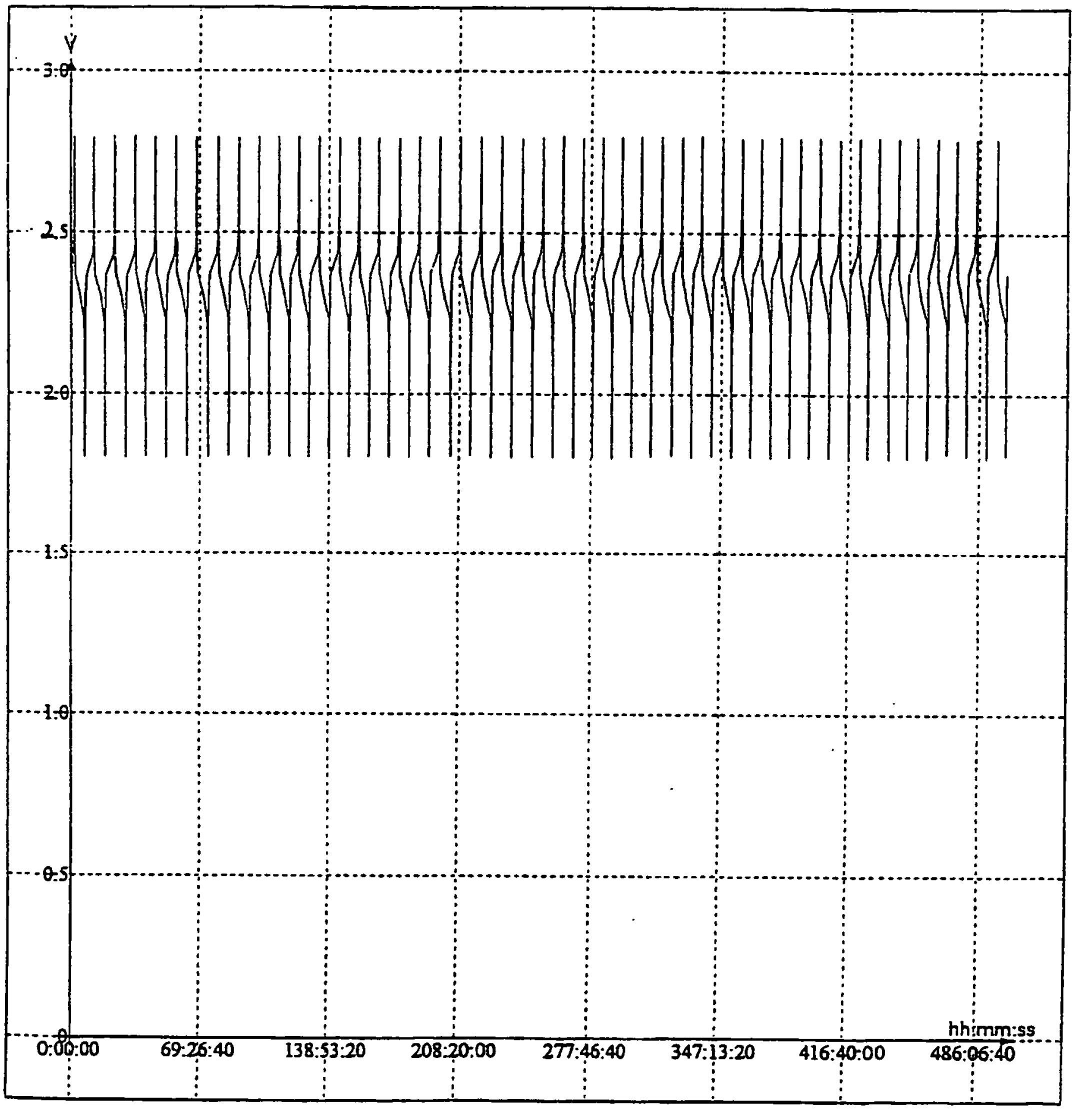
V
3.0
2.5
2.0
1.5
1.0
0.5
0
hh:mm:ss
0:00:00
69:26:40
138:53:20
208:20:00
277:46:40
347:13:20
416:40:00
486:06:40

Fig. 2

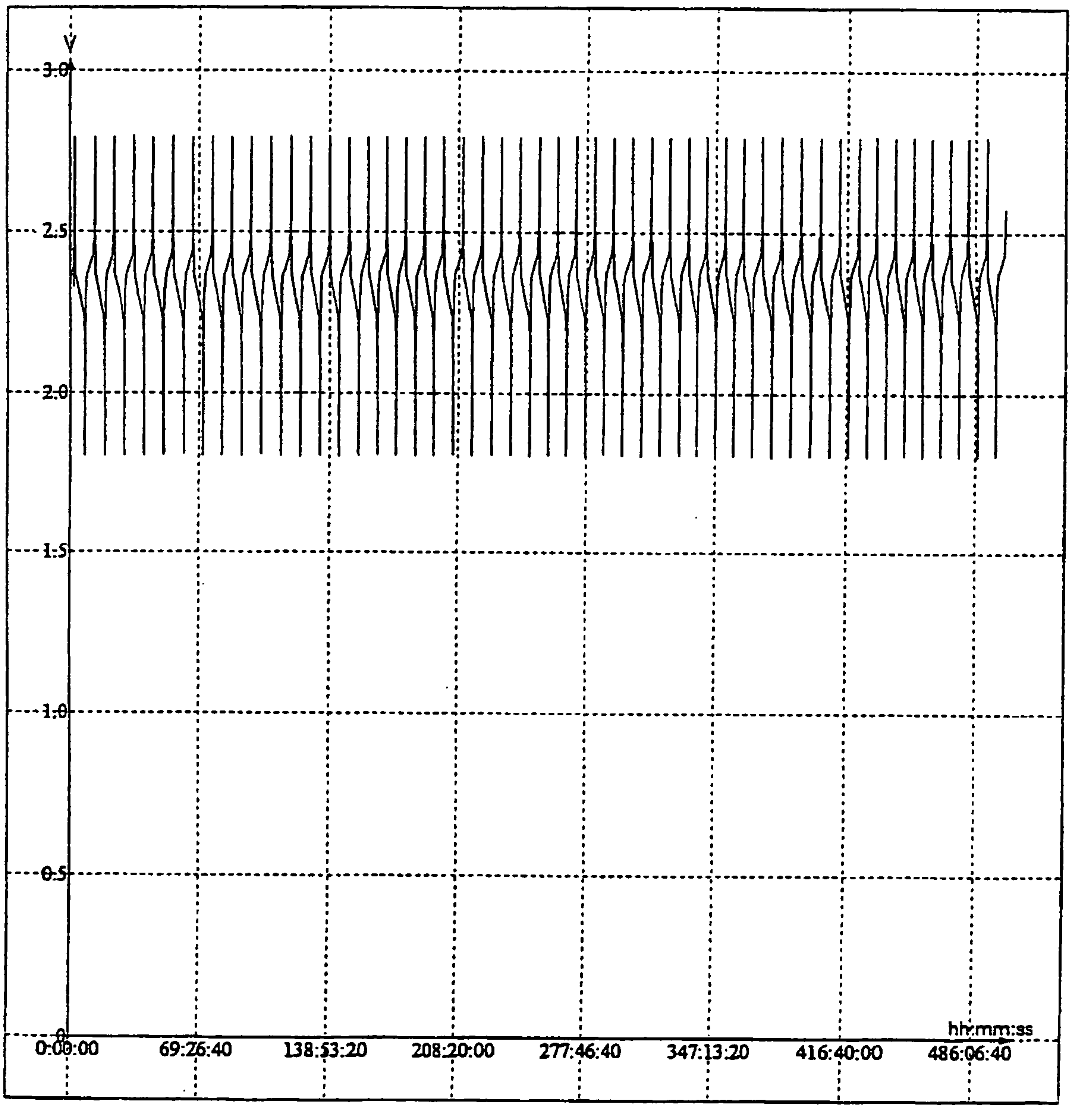
V
3.0
2.5
2.0
1.5
1.0
0.5
0
hh:mm:ss
0:00:00
69:26:40
138:53:20
208:20:00
277:46:40
347:13:20
416:40:00
486:06:40

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5009970 A
- US 5041346 A
- US 5707759 A
- US 5456000 A
- WO 9516285 A1
- WO 9749106 A
- US 5972055 A